# EUROPEAN PATENT SPECIFICATION

(11) **EP 4 488 536 B1**
(45) Date of publication and mention of the grant of the patent: **02.12.2026**
(21) Application number: 24773910.5
(22) Date of filing: 05.03.2024
(51) Int. Cl.: F16C 11/04, H04M 1/02, G06F 1/16

(54) **ROTATING SHAFT MECHANISM AND FOLDING ELECTRONIC DEVICE**
DREHWELLENMECHANISMUS UND KLAPPBARE ELEKTRONISCHE VORRICHTUNG
MÉCANISME D'ARBRE ROTATIF ET DISPOSITIF ÉLECTRONIQUE PLIABLE

(30) Priority: 22.03.2023 CN 202310319812
(43) Date of publication of application: 08.01.2025
(73) Proprietor: Huawei Technologies Co., Ltd., Shenzhen, Guangdong 518129 (CN)
(72) Inventor: SHEN, Hewen, Shenzhen, Guangdong 518129 (CN); WANG, Xuechan, Shenzhen, Guangdong 518129 (CN); LIAO, Li, Shenzhen, Guangdong 518129 (CN); YU, Lei, Shenzhen, Guangdong 518129 (CN); WU, Wenwen, Shenzhen, Guangdong 518129 (CN)
(74) Representative: Gill Jennings & Every LLP
(86) International application number: PCT/CN2024/080062
(87) International publication number: WO 2024/193342

(56) References cited:
- CN-A- 114 585 178
- CN-A- 115 494 913
- CN-U- 201 771 947
- CN-U- 216 057 087
- CN-U- 217 207 307
- CN-U- 217 582 862
- DE-A1- 4 428 557
- US-A1- 2005 064 918
- US-A1- 2022 004 232

## Description

### TECHNICAL FIELD

This application relates to the field of foldable screen technologies, and in particular, to a hinge mechanism and a foldable electronic device.

### BACKGROUND

As flexible foldable screen technologies are increasingly mature, foldable electronic devices have become a major trend. The foldable electronic devices (for example, foldable mobile phones, foldable tablets, foldable computers, and other electronic devices) need to have high reliability, good operation experience, and good appearances, so that the foldable electronic devices can be accepted by consumers.

As a core functional component of the foldable electronic device, a hinge mechanism is configured to drive parts of the foldable electronic device to rotate relative to each other. Stability of the hinge mechanism and damping formed by the hinge mechanism are closely related to user experience.

Portability of the foldable electronic device is increasingly improved, and space of the hinge mechanism is further compressed. When a volume of the hinge mechanism is limited, the stability of the hinge mechanism is usually sacrificed, and the damping formed by the hinge mechanism is reduced, resulting in poor user experience.

US 2022/004232 A1 describes a folding module and a foldable electronic device. A first protrusion and a first sliding slot are provided between a drive portion and a first connection member. A second protrusion and a second sliding slot are provided between the drive portion and a second connection member. A first drive spring and a second drive spring press against the drive portion. In a process in which the first support member folds or unfolds relative to the second support member, folding or unfolding can be implemented provided that the first support member and the second support member rotate by a relatively small angle, so that a speed of folding or unfolding of the first support member relative to the second support member is increased.

CN 217582862 U describes a folding device which comprises a rotating assembly, a linkage mechanism and a limiting mechanism, and the rotating assembly comprises a base and a rotating mechanism; the linkage mechanism comprises two rotating shafts connected to the base and two connecting rod pieces connected to the two rotating shafts correspondingly, and the two connecting rod pieces are slidably connected with the two rotating mechanisms correspondingly. The limiting mechanism comprises an abutting piece, an abutting piece, an elastic piece and a friction assembly which are arranged on the connecting rod piece, the rotating shaft is sleeved with the abutting piece, the abutting piece and the friction assembly, and the elastic piece provides elastic force enabling the abutting piece and the abutting piece to abut against each other; when the rotating mechanism rotates relative to the base, the connecting rod piece and the corresponding rotating shaft rotate around the axis of the rotating shaft together, so that the abutting and pushing piece rotates relative to the abutting and holding piece, and the connecting rod piece is positioned relative to the base through friction torsion between the abutting and pushing piece and the abutting and holding piece and friction resistance of the friction assembly. There is also described the electronic equipment provided with the folding device.

### SUMMARY

This application provides a hinge mechanism and a foldable electronic device, to improve a damping force of the hinge mechanism. The invention is set out in the appended claims. The implementations described below are not all claimed, they are included to help in understanding the context of the invention. While the description often refers to embodiments, the embodiments of the invention are those that comprise at least all the features of an independent claim. Any embodiment which does not fall within the scope of the claims does not form part of the invention, but is rather included as an illustrative example that is useful for understanding the invention.

A first aspect of embodiments of this application provides a hinge mechanism. The hinge mechanism includes a fastening support, a transmission assembly, two first transmission shafts, a clamping assembly, and a first elastic portion. The fastening support has two limiting holes provided at intervals in a first direction. The transmission assembly includes two first connecting members located on two sides of the fastening support in the first direction and a transmission gear group. Each first connecting member has one end gear, and the transmission gear group is located between two end gears and engaged with the two end gears. Each end gear is fixed relative to one first connecting member located on a same side, and each first connecting member is configured to be connected to one rotation portion located on a same side. The first transmission shaft extends in a second direction, the second direction is perpendicular to the first direction, the two first connecting members each rotate relative to the fastening support by using one first transmission shaft, and each first transmission shaft passes through a corresponding end gear and a corresponding limiting hole, to limit movement of the transmission assembly relative to the fastening support. The first transmission shaft is disposed on the clamping assembly. The clamping assembly cooperates around a circumference of the first transmission shaft relative to the fastening support in a limiting manner. The clamping assembly includes a first clamping member and a second clamping member. Both the first clamping member and the second clamping member are sleeved on the two first transmission shafts, and clamp the fastening support and the transmission assembly in the second direction. The first transmission shaft is connected to the second clamping member in a limiting manner in the second direction, so that the first transmission shaft can drive the second clamping member to be relatively close to the fastening support in the second direction. One end of the first elastic portion acts on the first clamping member, and the other end acts on the first transmission shaft, so that the first clamping member and the second clamping member clamp the fastening support and the transmission assembly in the second direction. The fastening support is located at an end of the end gears that faces away from the first clamping member, the first clamping member is located at an end of the transmission assembly that faces away from the fastening support, and the second clamping member is located at an end of the fastening support that faces away from the transmission assembly.

In the hinge mechanism, the two first connecting members drive two rotation portions to move synchronously through cooperation between the transmission gear group and the two end gears. The fastening support may be directly disposed on a fastening portion (base), so that relative positions between the fastening support and the fastening portion are fastened. Translation that is of the end gear disposed on the first transmission shaft and that is relative to the fastening support is limited through cooperation between the limiting hole on the fastening support and the first transmission shaft. A force on the end gear and misplacement of the end gear relative to the fastening support are reduced. The fastening support is disposed in the clamping assembly, and the fastening support is disposed in limited space to improve stability of the hinge mechanism. The first elastic portion acts on the first clamping member to provide a squeezing force for the first clamping member to abut against the first clamping member toward the fastening support. In addition, because the second clamping member is connected to the first transmission shaft in a limiting manner, the first clamping member and the second clamping member can clamp the fastening support and the transmission assembly under an elastic force. The first elastic portion enables at least three contact areas to be formed in total at a contact position between the first clamping member and the end gear, at a contact position between the end gear and the fastening support, and between the second clamping member and the fastening support, so that space of the hinge mechanism is fully utilized to form the at least three contact areas. When the end gear has a rotation trend, static friction generated in the three contact areas may form damping, and rotation of the end gear can be limited, so that the end gear can overcome a static friction force to rotate only when being subject to a driving force greater than the static friction force. The at least three contact areas expand an area in which the static friction force is generated, thereby increasing a value of the static friction force, and forming greater damping, to improve user experience obtained when a user rotates the two rotation portions. When the two rotation portions are at any relative angle and stop, the static friction force can limit the two rotation portions from rotating relative to each other again, to facilitate hovering of the two rotation portions. In this way, a more stable damping module of the hinge mechanism can be implemented in smaller space.

Based on the first aspect, in a possible implementation, the first clamping member is located at an end that is of the transmission assembly and that faces away from the fastening support, and an end that is of the first clamping member and that faces the fastening support has two first cam surfaces. An end that is of each first connecting member and that faces the first clamping member has a second cam surface. The first elastic portion enables the first clamping member and the second clamping member to clamp the fastening support and the transmission assembly in the second direction, and the second cam surface abuts against the first cam surface.

In the hinge mechanism, the first cam surface abuts against the second cam surface, so that self-driving of the end gear at a preset position can be implemented. For example, if the preset position is a position existing when the two rotation portions are in a folded state, when the two rotation portions are at positions of the folded state, a protrusion part of the first cam surface is completely inserted into a groove part of the second cam surface. When the two rotation portions approach positions of the folded state, due to an elastic force generated by the first elastic portion, a protrusion part of the first cam surface has a trend of entering a groove part of the second cam surface. In this way, the first connecting member has a trend of rotating relative to the first clamping member, so that the two rotation portions are driven by the first connecting members to have a trend of moving toward the folded state.

Based on the first aspect, in a possible implementation, the hinge mechanism further includes two second connecting members located on the two sides of the fastening support in the first direction, and each second connecting member is configured to be connected to one rotation portion located on a same side. The second clamping member is located at an end that is of the fastening support and that faces away from the transmission assembly, and an end that is of the second clamping member and that faces the fastening support has two third cam surfaces. Each second connecting member is disposed between the second clamping member and the fastening support. An end that is of each second connecting member and that faces the second clamping member has a fourth cam surface. The first clamping member and the second clamping member clamp the second connecting member, the fastening support, and the transmission assembly in the second direction, and the third cam surface abuts against the fourth cam surface.

In the hinge mechanism, stability of a connection between the rotation portion and the hinge mechanism can be improved by using the two second connecting members. When the first connecting member and the second connecting member are not directly fastened, the first connecting member and the second connecting member may independently generate a trend of moving in the second direction. When the rotation portion drives the first connecting member and the second connecting member to rotate around an axis center of the first transmission shaft, a friction area is formed between the second connecting member and the fastening support, and a friction area is also formed between the fastening support and the first connecting member. The two friction areas may form greater damping to increase stability of the end gear. When the two rotation portions are at any relative angle and stop, static friction forces formed in the two friction areas can limit the two rotation portions from rotating relative to each other again, to keep the two rotation portions hovering. When the first connecting member and the second connecting member are directly fastened, the first connecting member and the second connecting member can be connected to a corresponding rotation portion together, to facilitate assembling of the rotation portion and the hinge mechanism. In addition, self-driving of the second connecting member at a preset position is implemented by using the third cam surface and the fourth cam surface. For example, if the preset position is a position existing when the two rotation portions are in a folded state, when the two rotation portions are at positions of the folded state, a protrusion part of the third cam surface is completely inserted into a groove part of the fourth cam surface. When the two rotation portions approach positions of the folded state, due to an elastic force generated by the first elastic portion, a protrusion part of the third cam surface has a trend of entering a groove part of the fourth cam surface. In this way, the second connecting member has a trend of rotating relative to the second clamping member, so that the two rotation portions are driven by the second connecting members to have a trend of moving toward the folded state.

Based on the first aspect, in a possible implementation, the first connecting member and the second connecting member are fastened or integrated.

In the hinge mechanism, the first connecting member and the second connecting member can be connected to the corresponding rotation portion together, to facilitate the assembling of the rotation portion and the hinge mechanism.

Based on the first aspect, in a possible implementation, the fastening support includes a first part and a second part in the second direction, and the two limiting holes are provided on the first part. The second part is disposed between the two first transmission shafts, and is configured to be fastened to the fastening portion.

In the hinge mechanism, the first part has a large size in the first direction, so that the two limiting holes are conveniently provided, and the first part has a small size in the second direction. The limiting hole only needs to limit a position of the first transmission shaft. Reducing the size of the first part in the second direction helps reduce space occupied by the fastening support. The second part has a small size in the first direction, so that the space occupied by the fastening support is reduced.

Based on the first aspect, in a possible implementation, the transmission gear group includes a middle gear. The hinge mechanism further includes a second transmission shaft, and the second transmission shaft extends in the second direction. The fastening support further has a limiting slot, and the second transmission shaft passes through the middle gear and is inserted into the limiting slot, to limit movement of the middle gear relative to the fastening support.

In the hinge mechanism, the second transmission shaft is connected to the middle gear. The fastening support limits a position of the second transmission shaft by using the limiting slot, to reduce misplacement of the middle gear relative to the fastening portion when the middle gear is subject to a force.

Based on the first aspect, in a possible implementation, the first elastic portion includes a first elastic member and a first positioning member. The first positioning member is disposed on the first transmission shaft, and is located on a side that is of the first clamping member and that faces away from the second clamping member. The first elastic member is clamped between the first clamping member and the first positioning member.

In the hinge mechanism, one end of the first elastic member acts on the first clamping member, and the other end indirectly acts on the second clamping member through transmission of the first positioning member and the first transmission shaft, so that the first clamping member and the second clamping member tend to be relatively close to each other. In this way, the first clamping member and the second clamping member act on the fastening support and the transmission assembly to form a static friction force. The first elastic member is disposed at a position that is on the first clamping member and that faces away from the second clamping member, and does not occupy space of the fastening support and the transmission assembly.

Based on the first aspect, in a possible implementation, a first stop member and a second stop member are disposed on the first transmission shaft. The first stop member acts on the first positioning member, to limit the first positioning member from being detached from the first transmission shaft in the second direction. The second stop member acts on the second clamping member, to limit the second clamping member from being detached from the first transmission shaft in the second direction.

In the hinge mechanism, the first stop member limits a position of the first positioning member, and the second stop member limits a position of the second clamping member, so that the first elastic member indirectly acts on the second clamping member through the transmission of the first positioning member and the first transmission shaft.

Based on the first aspect, in a possible implementation, the hinge mechanism further includes a second elastic portion and a third clamping member. Both the second elastic portion and the third clamping member are disposed on the second transmission shaft. The middle gear is clamped between the fastening support and the third clamping member. The second elastic portion acts on the third clamping member to press the third clamping member toward the middle gear in the second direction.

In the hinge mechanism, the second elastic portion acts on the third clamping member to press the third clamping member toward the middle gear. The third clamping member can also press the middle gear toward the fastening support. A friction area is formed between the middle gear and the fastening support, and a friction area is also formed between the third clamping member and the middle gear. The two friction areas can form greater damping. The middle gear and the end gear drive cooperate with each other through transmission. The greater damping formed in the two friction areas can also increase the stability of the end gear.

Based on the first aspect, in a possible implementation, the third clamping member is located at the end that is of the transmission assembly and that faces away from the fastening support, and an end that is of the third clamping member and that faces the fastening support has two fifth cam surfaces. An end that is of each middle gear and that faces the third clamping member has a sixth cam surface. The second elastic portion enables the third clamping member to press the middle gear in the second direction, and the fifth cam surface abuts against the sixth cam surface.

In the hinge mechanism, self-driving of the middle gear at a preset position is implemented by using the fifth cam surface and the sixth cam surface, to indirectly implement self-driving of the end gear at the preset position. For example, if the preset position is a position existing when the two rotation portions are in a folded state, when the two rotation portions are at positions of the folded state, a protrusion part of the fifth cam surface is completely inserted into a groove part of the sixth cam surface. When the two rotation portions approach positions of the folded state, due to an elastic force generated by the second elastic portion, a protrusion part of the fifth cam surface has a trend of entering a groove part of the sixth cam surface. In this way, the middle gear has a trend of rotating relative to the third clamping member, so that the two rotation portions are driven by the middle gear by using the end gear to have a trend of moving toward the folded state.

Based on the first aspect, in a possible implementation, the third clamping member and the first clamping member are fastened or integrated.

In the hinge mechanism, the third clamping member and the first clamping member may be pre-assembled, and then cooperate with the first transmission shaft and the second transmission shaft. When the third clamping member and the first clamping member are integrated, manufacturing and molding of the third clamping member and the first clamping member may be further facilitated, and a quantity of parts in the hinge mechanism is reduced.

The second elastic portion includes a second elastic member and a second positioning member. The second positioning member is disposed on the second transmission shaft, and is located on a side that is of the third clamping member and that faces away from the middle gear. The second elastic member is clamped between the third clamping member and the second positioning member, and the second elastic member acts on the third clamping member and the second positioning member, so that the third clamping member presses the middle gear toward the fastening support in the second direction.

In the hinge mechanism, one end of the second elastic member in the second elastic portion acts on the third clamping member, and the other end acts on the second positioning member, so that the third clamping member and the second positioning member tend to be relatively far away from each other, and the third clamping member acts on the middle gear to form a static friction force.

Based on the first aspect, in a possible implementation, the first positioning member and the second positioning member are fastened or integrated.

In the hinge mechanism, the first positioning member has limited the position in the second direction by using the first transmission shaft, and the second positioning member is fastened to the first positioning member, so that a position of the second positioning member in the second direction may also be limited. When the first positioning member and the second positioning member are integrated, manufacturing and molding of the first positioning member and the second positioning member may be further facilitated, and a quantity of parts in the hinge mechanism is reduced.

Based on the first aspect, in a possible implementation, the fastening support has a bolt hole, and the bolt hole is used for a bolt to pass through to connect the fastening support and the fastening portion.

In the hinge mechanism, the fastening support is detachably connected to the fastening portion through the bolt, to facilitate assembling of and cooperation between the fastening portion and the fastening support.

A second aspect of this application provides a foldable electronic device. The foldable electronic device includes a first housing and a second housing. The foldable electronic device further includes the hinge mechanism according to any one of the implementations of the first aspect. The first housing is connected to one first connecting member, and the second housing is connected to the other first connecting member. The first housing and the second housing rotate toward each other or away from each other by using the hinge mechanism.

In the foldable electronic device, the first housing is connected to the second housing through the hinge mechanism, so that the first housing and the second housing can rotate toward each other or away from each other synchronously. In this way, the foldable electronic device is in an unfolded state or a folded state. When the first housing and the second housing rotate toward each other or away from each other, movement of the end gear disposed on the transmission shaft relative to the fastening support is limited through cooperation between the limiting hole on the fastening support and the first transmission shaft, and misplacement of the end gear relative to the fastening portion is reduced when the end gear is subject to a force. In this way, the first housing and the second housing rotate more smoothly. In addition, the first elastic portion enables the first clamping member and the second clamping member to form two contact areas on two sides of the fastening support and the transmission assembly, so that space of the hinge mechanism is fully utilized to form the two contact areas. When the end gear has a rotation trend, static friction generated in the two contact areas may form damping, and rotation of the end gear can be limited, so that the end gear can overcome a static friction force to rotate only when being subject to a driving force greater than the static friction force. After the first housing and the second housing stop rotating, and before the first housing and the second housing are driven by a large enough external force to rotate relative to each other, relative positions of the first housing and the second housing are kept, to implement hovering of the first housing and the second housing.

### BRIEF DESCRIPTION OF DRAWINGS

FIG. 1 is a diagram of assembling of a foldable electronic device according to an implementation of this application;
FIG. 2 is a diagram of a structure of a foldable electronic device according to an implementation of this application, where the foldable electronic device is in an unfolded state;
FIG. 3 is a diagram of a structure of a foldable electronic device according to an implementation of this application, where the foldable electronic device is in a folded state;
FIG. 4 is a diagram of a structure of a hinge mechanism connected to a rotation portion according to an implementation of this application;
FIG. 5 is a diagram of assembling of a hinge mechanism according to an implementation of this application;
FIG. 6 is a diagram of a structure of a hinge mechanism according to an implementation of this application;
FIG. 7 is a diagram of a structure of a hinge mechanism viewed from another angle according to an implementation of this application;
FIG. 8 is a diagram of assembling of a hinge mechanism according to an implementation of this application;
FIG. 9 is a diagram of a structure of a hinge mechanism according to an implementation of this application; and
FIG. 10 is a diagram of a structure of a hinge mechanism viewed from another angle according to an implementation of this application.

**Description of reference signs of main components:**

| | |
|---|---|
| foldable electronic device | 001 |
| first housing | 010 |
| second housing | 030 |
| base | 050 |
| fastening portion | 051 |
| hinge mechanism | 070 |
| snap ring | 071 |
| four-conjoined cam | 073 |
| two-conjoined gear | 075 |
| rotation portion | 077 |
| fastening support | 100 |
| limiting hole | 101 |
| limiting slot | 103 |
| first part | 110 |
| second part | 130 |
| bolt hole | 131 |
| transmission assembly | 200 |
| transmission gear group | 210 |
| middle gear | 211 |
| first transmission shaft | 220 |
| first stop member | 221 |
| annular groove | 223 |
| second stop member | 225 |
| first connecting member | 230 |
| end gear | 231 |
| first mounting hole | 233 |
| clamping assembly | 300 |
| first clamping member | 310 |
| second clamping member | 330 |
| first elastic portion | 400 |
| first elastic member | 410 |
| first positioning member | 430 |
| second cam surface | 511 |
| first cam surface | 513 |
| fourth cam surface | 531 |
| third cam surface | 533 |
| sixth cam surface | 551 |
| fifth cam surface | 553 |
| second connecting member | 610 |
| second transmission shaft | 710 |
| third stop member | 711 |
| second elastic portion | 800 |
| second elastic member | 810 |
| second positioning member | 830 |
| third clamping member | 910 |
| first direction | X |
| second direction | Y |

In the following specific implementations, this application is further described with reference to the accompanying drawings.

### DESCRIPTION OF EMBODIMENTS

The following describes implementations of this application by using specific embodiments. A person skilled in the art may easily understand other advantages and effect of this application based on content disclosed in this specification. Although this application is described with reference to example embodiments, it does not mean that features of this application are limited to the implementations. On the contrary, a purpose of descriptions of this application with reference to the implementations is to cover another option or modification that may be derived according to claims of this application. To provide a deep understanding of this application, the following descriptions include many specific details. This application may alternatively be implemented without using these details. In addition, to avoid confusion or obfuscation of a focus of this application, some specific details are omitted from the descriptions. It should be noted that embodiments in this application and the features in embodiments may be mutually combined in a case of no conflict.

The following terms "first", "second", and the like are merely used for description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two. Orientation terms such as "up", "down", "left", and "right" are defined relative to orientations of components schematically placed in the accompanying drawings. It should be understood that these orientation terms are relative concepts used for relative description and clarification, and may change correspondingly based on a change in an orientation in which the component is placed in the accompanying drawings.

In this application, unless otherwise explicitly specified and limited, a term "connection" should be understood in a broad sense. For example, the "connection" may indicate a fixed connection, a detachable connection, or an integral connection; or may indicate direct interconnection, or indirect interconnection through an intermediate medium. A term "and/or" used in this specification includes any and all combinations of one or more related listed items.

When the following embodiments are described in detail with reference to diagrams, for ease of description, a diagram indicating a partial structure of a component is partially enlarged not based on a general scale. In addition, the diagrams are merely examples, and should not limit a protection scope of this application herein.

To make objectives, technical solutions, and advantages of this application clearer, the following further describes the implementations of this application in detail with reference to the accompanying drawings.

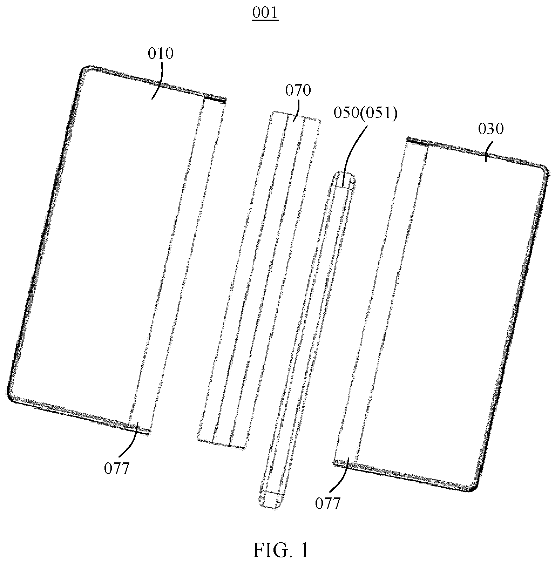

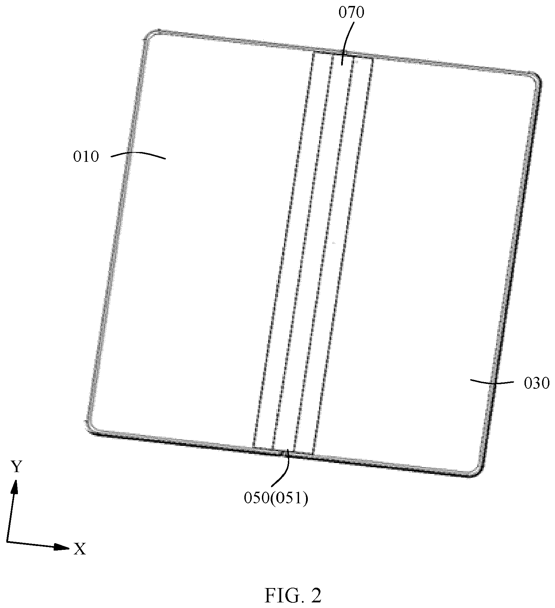

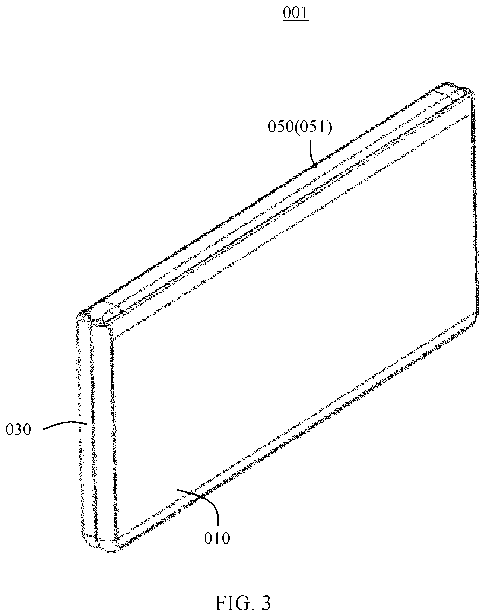

FIG. 1 is a diagram of assembling of a foldable electronic device 001 according to an implementation of this application. FIG. 2 is a diagram of a structure of the foldable electronic device 001 according to an implementation of this application, where the foldable electronic device 001 is in an unfolded state. FIG. 3 is a diagram of a structure of the foldable electronic device 001 according to an implementation of this application, where the foldable electronic device 001 is in a folded state.

As shown in FIG. 1 and FIG. 2, the foldable electronic device 001 includes a first housing 010, a second housing 030, and a base 050. The first housing 010 and the second housing 030 are respectively disposed on two sides of the base 050 in a first direction X. As shown in FIG. 2 and FIG. 3, the first housing 010 and the second housing 030 may rotate toward each other or away from each other. The first housing 010 and the second housing 030 rotate away from each other, so that the foldable electronic device 001 can move to be in the unfolded state. The first housing 010 and the second housing 030 rotate toward each other, so that the foldable electronic device 001 can move to be in the folded state.

A flexible display may be disposed on the first housing 010, the base 050, and the second housing 030. When the foldable electronic device 001 moves to be in the unfolded state, the flexible display is also unfolded, and the entire flexible display can be completely observed by a user, so that a visible area of the flexible display is expanded. When the foldable electronic device 001 moves to be in the folded state, the flexible display is also folded, so that portability of the foldable electronic device 001 is improved. If the flexible display is disposed on an inner side of the foldable electronic device 001, when the foldable electronic device 001 is in the folded state, the flexible display is shielded and protected by the first housing 010, the second housing 030, and the base 050, to reduce a probability that the flexible display is damaged. If the flexible display is disposed on an outer side of the foldable electronic device 001, when the foldable electronic device 001 is in the folded state, the flexible display is also divided into a first area located in the first housing 010 and a second area located in the second housing 030. The first area and the second area may display different content, to extend a function of the foldable electronic device 001.

The foldable electronic device 001 further includes a hinge mechanism 070. The base 050 forms a fastening portion 051 to be connected to the hinge mechanism 070. The hinge mechanism 070 is disposed on the base 050. Two rotation portions 077 may be further disposed on the hinge mechanism 070, the first housing 010 is fastened to one rotation portion 077, and the second housing 030 is also fastened to the other rotation portion 077. When the first housing 010 rotates relative to the base 050, the hinge mechanism 070 may drive the second housing 030 to rotate synchronously relative to the base 050.

It may be understood that the base 050 covering a gap between the first housing 010 and the second housing 030 is not disposed in the foldable electronic device 001. For example, the foldable electronic device 001 includes a fastening plate. The fastening plate is located between the first housing 010 and the second housing 030, two sides of the fastening plate are respectively rotatably connected to the first housing 010 and the second housing 030, and the fastening plate is connected to the hinge mechanism 070. The fastening plate covers only a part of the hinge mechanism 070, and a flexible housing is disposed on a side that is of the fastening plate and that faces away from the hinge mechanism 070, to cover the gap between the first housing 010 and the second housing 030. The flexible housing may be made of leather.

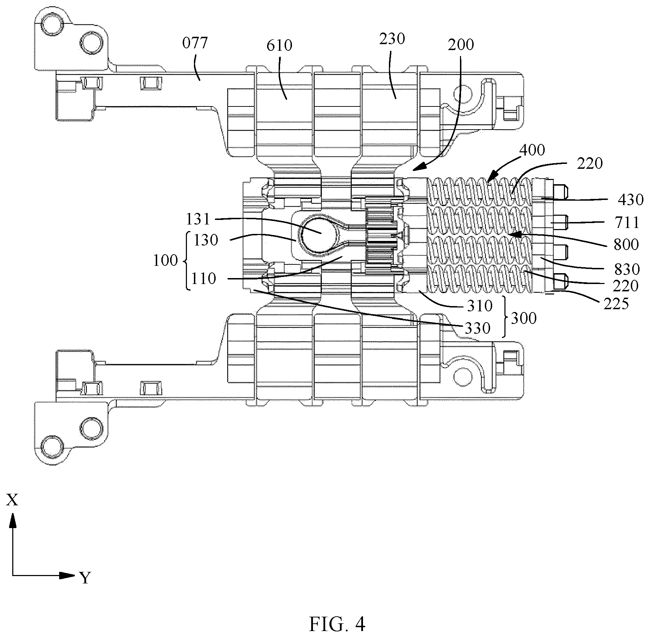

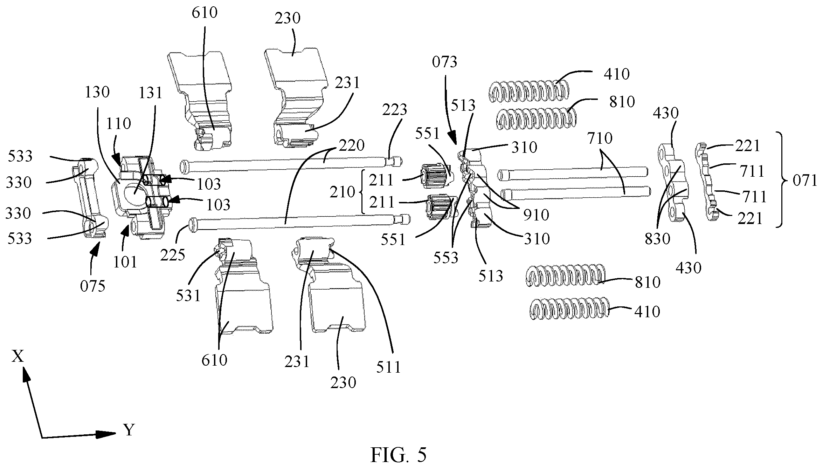

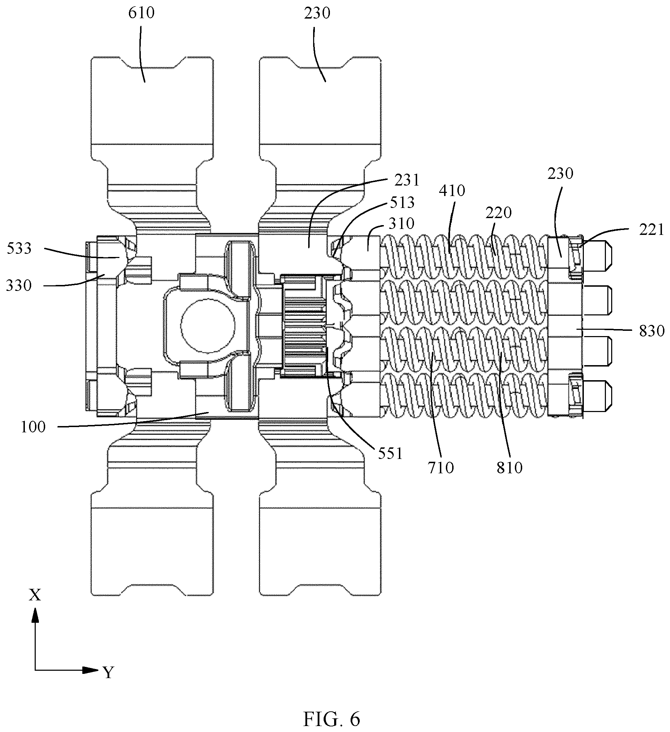

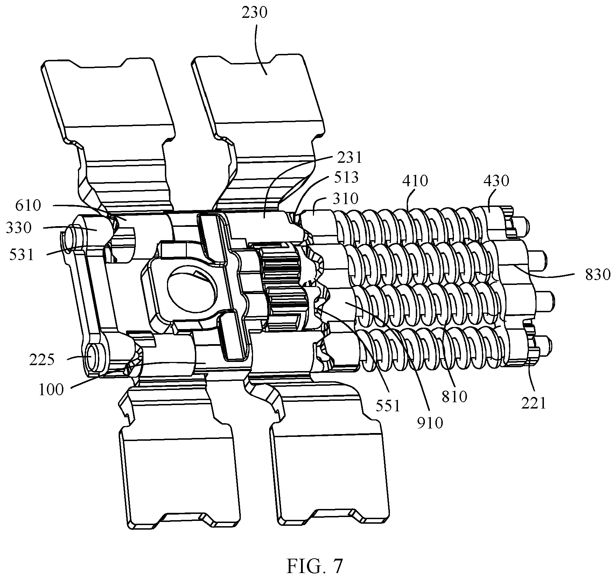

FIG. 4 is a diagram of a structure of the hinge mechanism 070 connected to the rotation portion 077 according to an implementation of this application. FIG. 5 is a diagram of assembling of the hinge mechanism 070 according to an implementation of this application. FIG. 6 is a diagram of a structure of the hinge mechanism 070 according to an implementation of this application. FIG. 7 is a diagram of a structure of the hinge mechanism 070 viewed from another angle according to an implementation of this application.

Refer to FIG. 4 and FIG. 5. The hinge mechanism 070 includes a fastening support 100. The fastening support 100 includes a first part 110 and a second part 130. The first part 110 and the second part 130 are integrated, so that the first part 110 and the second part 130 can be integrally formed to keep the first part 110 and the second part 130 fastened in relative positions. The fastening support 100 is provided with a bolt hole 131. A bolt passes through the bolt hole 131 and cooperates with a thread of the base 050, so that the fastening support 100 is connected to the base 050, to fasten relative positions of the base 050 and the fastening support 100. The bolt hole 131 is completely or partially located in the second part 130. The second part 130 expands space of the fastening support 100, to facilitate arrangement of the bolt hole 131. A bolt with a large size can pass through the bolt hole 131 and be fastened to the base 050, to improve strength of the connection between the fastening support 100 and the base 050.

The first part 110 and the second part 130 are arranged in a second direction Y. The second direction Y is perpendicular to the first direction X. Optionally, a size of the second part 130 in the first direction X is less than a size of the first part 110 in the first direction X. Two ends of the first part 110 in the first direction X protrude relative to the second part 130. One limiting hole 101 is provided in each of two local areas that are of the first part 110 and that protrude from the second part 130. The limiting hole 101 is a through hole that penetrates in the second direction Y

The hinge mechanism 070 further includes a transmission assembly 200. The transmission assembly 200 includes first connecting members 230 located on two sides of the fastening support 100 in the first direction X. The transmission assembly 200 further includes a transmission gear group 210. Each first connecting member 230 has one end gear 231, and the transmission gear group 210 is located between two end gears 231. The two end gears 231 are respectively engaged on two sides of the transmission gear group 210 in the first direction X. One first connecting member 230 is connected to the rotation portion 077 on a side of the first housing 010, and the other first connecting member 230 is connected to the rotation portion 077 on a side of the second housing 030. In a possible embodiment, one first connecting member 230 is slidably connected to the rotation portion 077 on the side of the first housing 010, and the other first connecting member 230 is slidably connected to the rotation portion 077 on the side of the second housing 030. When the first housing 010 or the second housing 030 moves relative to the hinge mechanism 070, a corresponding first connecting member 230 is driven to move, to drive a corresponding end gear 231 to rotate. The transmission gear group 210 is configured to transfer a rotation amount of one end gear 231 to the other end gear 231. Optionally, the transmission gear group 210 includes two meshed middle gears 211. When one end gear 231 rotates in a first rotation direction, the other end gear 231 rotates in a second rotation direction through transmission of the two middle gears 211. The first rotation direction is opposite to the second rotation direction, so that the first housing 010 and the second housing 030 can rotate toward each other or away from each other synchronously. Optionally, the end gear 231 is an incomplete gear. The end gear 231 drives the first housing member and the second housing member to move between the unfolded state and the folded state. Correspondingly, the end gear 231 only needs to be disposed with a gear in a corresponding rotation range.

Refer to FIG. 4, FIG. 5, and FIG. 6. The hinge mechanism 070 further includes two first transmission shafts 220. The two first transmission shafts 220 are in one-to-one correspondence with the two first connecting members 230. The first transmission shaft 220 extends in the second direction Y. The first transmission shaft 220 passes through a first mounting hole 233 of a corresponding end gear 231 and the limiting hole 101 of the fastening support 100, to connect the first transmission shaft 220, the end gear 231, and the fastening support 100. Each first connecting member 230 rotates relative to the fastening support 100 by using a corresponding first transmission shaft 220. The fastening support 100 limits a position of the first transmission shaft 220, so that it is difficult for the first transmission shaft 220 to translate in each direction perpendicular to the second direction Y relative to the fastening support 100. The first transmission shaft 220 further limits a position of the end gear 231, so that it is difficult for the end gear 231 to translate in each direction perpendicular to the second direction Y relative to the first transmission shaft 220. The fastening support 100, the first transmission shaft 220, and the end gear 231 cooperate, so that a position of the end gear 231 relative to the base 050 is stable. When the first housing 010 and the second housing 030 are driven to rotate relative to each other, the end gear 231 can rotate stably and is not easy to translate relative to the base 050.

The hinge mechanism 070 further includes a clamping assembly 300. The clamping assembly 300 includes a first clamping member 310 and a second clamping member 330. Both the first clamping member 310 and the second clamping member 330 are sleeved on the first transmission shaft 220. In the second direction Y, the first clamping member 310 is located at an end that is of the transmission assembly 200 and that faces away from the fastening support 100. In the second direction Y, the second clamping member 330 is located at an end that is of the fastening support 100 and that faces away from the transmission assembly 200. The fastening support 100 and the transmission assembly 200 are clamped between the first clamping member 310 and the second clamping member 330. The first clamping member 310 cooperates around a circumference of the first transmission shaft 220 relative to the fastening support 100 in a limiting manner, and the second clamping member 330 cooperates around the circumference of the first transmission shaft 220 relative to the fastening support 100 in a limiting manner. When the end gear 231 rotates around an axis center of the first transmission shaft 220, none of the first clamping member 310, the second clamping member 330, and the fastening support 100 rotates around the axis center of the first transmission shaft 220, so that the end gear 231 and the first clamping member 310 rotate relative to each other, to form damping between the end gear 231 and the first clamping member 310. The second clamping member 330 is further connected to the first transmission shaft 220 in a limiting manner in the second direction Y When the first transmission shaft 220 moves parallel to the second direction Y and along a direction from the second clamping member 330 to the fastening support 100, the second clamping member 330 may be driven to be relatively close to the fastening support 100.

Optionally, the first clamping member 310 is sleeved on the two first transmission shafts 220. The second clamping member 330 is sleeved on the two first transmission shafts 220. Two parts that are of the first clamping member 310 and that correspond to the two first transmission shafts 220 may be fastened. For example, the first clamping member 310 is a part of two ends that are of one four-conjoined cam and that are in the first direction X. Relative positions of the two first transmission shafts 220 are fastened by using the fastening support 100, so that the four-conjoined cam cannot rotate around an axis center of any one of the first transmission shafts 220. In this case, the first clamping member 310 cooperates around the circumference of the first transmission shaft 220 relative to the fastening support 100 in a limiting manner. When the end gear 231 rotates around the axis center of the first transmission shaft 220, the end gear 231 and the first clamping member 310 rotate relative to each other, so that damping is formed between the first clamping member 310 and the end gear 231. Two parts that are of the second clamping member 330 and that correspond to the two first transmission shafts 220 may also be fastened. The second clamping member 330 is a part of two ends that are of one two-conjoined cam and that are in the first direction X. The relative positions of the two first transmission shafts 220 are fastened by using the fastening support 100, so that the two-conjoined cam cannot rotate around an axis center of any one of the first transmission shafts 220. It may be understood that the first clamping member 310 and the second clamping member 330 may not rotate around the first transmission shaft 220 relative to the fastening support 100. Therefore, the first clamping member 310 and the second clamping member 330 may alternatively be connected to the first transmission shaft 220 in another form. For example, each first transmission shaft 220 is connected to the circumference of the fastening support 100 in a limiting manner, and two parts at two ends that are of the first clamping member 310 and that are in the first direction X are separated, and are both connected to a circumference of a corresponding first transmission shaft 220 in a limiting manner; and each first transmission shaft 220 is connected to the circumference of the fastening support 100 in a limiting manner, and two parts that are of the second clamping member 330 and that correspond to the two first transmission shafts 220 are separated, and are both connected to a circumference of a corresponding first transmission shaft 220 in a limiting manner.

The hinge mechanism 070 further includes a first elastic portion 400. The first elastic portion 400 is disposed on the first transmission shaft 220. The first elastic portion 400 is in a force storage state. The first elastic portion 400 provides elastic forces for the first clamping member 310 and the second clamping member 330, so that the first clamping member 310 and the second clamping member 330 clamp the fastening support 100 and the transmission assembly 200 in the second direction Y. Optionally, the first elastic portion 400 includes a first elastic member 410 and a first positioning member 430. One first elastic member 410 is sleeved on each first transmission shaft 220. The first positioning member 430 is disposed on the first transmission shaft 220, and is located on a side that is of the first clamping member 310 and that faces away from the second clamping member 330. The first positioning member 430 and the first clamping member 310 are disposed at intervals in the second direction Y, and the first elastic member 410 is clamped between the first positioning member 430 and the first clamping member 310. The first elastic member 410 is in the force storage state, and the first elastic member 410 generates an elastic force that makes the first positioning member 430 and the first clamping member 310 relatively far away from each other. When relative movement of the first positioning member 430 and the first transmission shaft 220 in the second direction Y is limited, relative movement of the second clamping member 330 and the first transmission shaft 220 in the second direction Y is also limited, so that the first positioning member 430 and the second clamping member 330 cannot be relatively far away from each other. In this case, an elastic force of the first elastic member 410 acts on the second clamping member 330 by using the first positioning member 430 and the first transmission shaft 220, so that the first clamping member 310 and the second clamping member 330 tend to be relatively close to each other. In this way, the first clamping member 310 and the second clamping member 330 clamp the fastening support 100 and the end gear 231 in the second direction Y.

Optionally, the first elastic member 410 is a compression spring; and when the compression spring is compressed, elastic potential energy can be stored, and an elastic force can be generated. As the compression spring is further compressed, the compression spring can generate a greater elastic force. When the compression spring is elongated, the elastic potential energy is released and a generated elastic force is reduced. Optionally, when the two ends that are of the four-conjoined cam and that are in the first direction X form the first clamping member 310, two first elastic members 410 simultaneously act on the four-conjoined cam, to drive the four-conjoined cam to be close to the transmission assembly 200.

Optionally, a first stop member 221 is disposed on the first transmission shaft 220. The first stop member 221 is disposed at an end that is of the first positioning member 430 and that faces away from the second clamping member 330. A first guide hole is provided on the first positioning member 430. The first transmission shaft 220 passes through the first guide hole to limit relative movement of the first positioning member 430 and the first transmission shaft 220. Along a projection surface perpendicular to the second direction Y, a projection of the first stop member 221 is at least partially located outside the first guide hole. In this way, when the first positioning member 430 moves to be in contact with the first stop member 221, the first stop member 221 may limit the first positioning member 430 from passing through the first stop member 221 in the second direction Y, to limit the first positioning member 430 from being detached from the first transmission shaft 220 in the second direction Y.

Optionally, the first stop member 221 includes a snap ring 071. An annular groove 223 is provided on a rod body of the first transmission shaft 220, and the snap ring 071 has a clamping groove. A shape of the clamping groove is equivalent to a shape of the annular groove 223, and an opening is provided on one side of the clamping groove. When the snap ring 071 and the rod body of the first transmission shaft 220 are assembled, the opening of the clamping groove is first aligned with the annular groove 223, the snap ring 071 approaches the rod body in a direction perpendicular to the second direction Y, and a part that is of the rod body and that is disposed with the annular groove 223 enters the clamping groove from the opening. A size of the opening is less than a diameter of the part that is of the rod body and that is disposed with the annular groove 223. However, the snap ring 071 has specific elasticity. The opening is enlarged through deformation of the snap ring 071, so that the part that is of the rod body and that is disposed with the annular groove 223 enters the clamping groove through the opening. After the part that is of the rod body and that is disposed with the annular groove 223 enters the clamping groove, a shape of the snap ring 071 is restored, and the opening becomes smaller to prevent the part that is of the rod body and that is disposed with the annular groove 223 from sliding out of the opening. An end face of the annular groove 223 limits movement of the snap ring 071 relative to the first transmission shaft 220 in the second direction Y. The snap ring 071 acts on the first positioning member 430, and further limits movement of the first positioning member 430 relative to the first transmission shaft 220 in the second direction Y.

It may be understood that the first positioning member 430 and the second clamping member may alternatively be fastened on the first transmission shaft 220. The end gear 231 is rotatably connected to the first transmission shaft 220 around the axis center of the first transmission shaft 220. The first positioning member 430 and the second clamping member can move synchronously with the first transmission shaft 220 in the second direction Y. The end gear 231 may rotate around the axis center of the first transmission shaft 220 relative to the fastening support 100.

Optionally, with reference to FIG. 4 and FIG. 5, a second stop member 225 is disposed on the first transmission shaft 220. The second stop member 225 is disposed at an end that is of the second clamping member 330 and that faces away from the first positioning member 430. A second guide hole is provided on the second clamping member 330. The first transmission shaft 220 passes through the second guide hole to limit relative movement of the second clamping member 330 and the first transmission shaft 220. Along the projection surface perpendicular to the second direction Y, a projection of the second stop member 225 is at least partially located outside the second guide hole. In this way, when the second clamping member 330 moves to be in contact with the second stop member 225, the second stop member 225 may limit the second clamping member 330 from passing through the second stop member 225 in the second direction Y, to limit the second clamping member 330 from being detached from the first transmission shaft 220 in the second direction Y. The second stop member 225 enables the second clamping member 330 to be further connected to the first transmission shaft 220 in a limiting manner in the second direction Y. When the first transmission shaft 220 moves parallel to the second direction Y and along the direction from the second clamping member 330 to the fastening support 100, the second clamping member 330 may be driven to be relatively close to the fastening support 100.

When the first connecting member 230 drives the end gear 231 to rotate around the axis center of the first transmission shaft 220, the end gear 231 moves relative to the first clamping member 310. The first elastic portion 400 enables the first clamping member 310 to press the end gear 231 tightly, so that damping is formed between the end gear 231 and the first clamping member 310.

It may be understood that, if the hinge mechanism 070 is not provided with the first positioning member 430, an end that is of the first elastic portion 400 and that faces away from the fastening support 100 may alternatively be fastened on the first transmission shaft 220. For example, an end that is of the first elastic member 410 and that faces away from the fastening support 100 is welded to the first transmission shaft 220.

Optionally, an end that is of the first clamping member 310 and that faces the fastening support 100 has two first cam surfaces 513. An end that is of each first connecting member 230 and that faces the first clamping member 310 has a second cam surface 511. The second cam surface 511 rotates as the end gear 231 rotates. Because the first clamping member 310 cooperates around the circumference of the first transmission shaft 220 relative to the fastening support 100 in a limiting manner, the first cam surface 513 does not rotate as the end gear 231 rotates. The second cam surface 511 has a protrusion part and a groove part that are disposed around the circumference of the first transmission shaft 220, and the first cam surface 513 also has a protrusion part and a groove part that are disposed around the circumference of the first transmission shaft 220. When the protrusion part of the second cam surface 511 is inserted into the groove part of the first cam surface 513, the protrusion part of the first cam surface 513 is also inserted into the groove part of the second cam surface 511. The first elastic portion 400 acts on the first clamping member 310, so that the first clamping member 310 has a trend of moving toward the end gear 231, and the first cam surface 513 presses the second cam surface 511 tightly. When the protrusion part of the first cam surface 513 is not completely inserted into the groove part of the second cam surface 511, an elastic force provided by the first elastic portion 400 enables the protrusion part of the first cam surface 513 to have a trend of being further inserted into the groove part of the second cam surface 511. In addition, contact between the second cam surface 511 and the first cam surface 513 also generates a friction force, and the friction force may limit the protrusion part of the first cam surface 513 from being further inserted into the groove part of the second cam surface 511. Corresponding to the foldable electronic device 001 shown in FIG. 2, in a process in which the foldable electronic device 001 moves from the unfolded state to the folded state, when the first housing 010 and the second housing 030 are in an intermediate state between the unfolded state and the folded state, the friction force between the second cam surface 511 and the first cam surface 513 may help the first housing 010 and the second housing 030 maintain the intermediate state, and assist in implementing hovering of the first housing 010 and the second housing 030.

When the foldable electronic device 001 is in the unfolded state, the protrusion part of the second cam surface 511 is completely inserted into the groove part of the first cam surface 513. In this case, if the second cam surface 511 and the first cam surface 513 need to rotate relative to each other, a static friction force between the second cam surface 511 and the first cam surface 513 needs to be overcome, and an elastic force that the first elastic portion 400 prevents the second cam surface 511 and the first cam surface 513 from being relatively far away from each other in the second direction Y also needs to be overcome. Cooperation between the second cam surface 511 and the first cam surface 513 may limit the foldable electronic device 001 to be in the unfolded state more stably.

When the foldable electronic device 001 is in the folded state, the protrusion part of the second cam surface 511 is completely inserted into the groove part of the first cam surface 513. In this case, if the second cam surface 511 and the first cam surface 513 need to rotate relative to each other, a static friction force between the second cam surface 511 and the first cam surface 513 needs to be overcome, and an elastic force that the first elastic portion 400 prevents the second cam surface 511 and the first cam surface 513 from being relatively far away from each other in the second direction Y also needs to be overcome. Cooperation between the second cam surface 511 and the first cam surface 513 may limit the foldable electronic device 001 to be in the folded state more stably. It may be understood that, that the protrusion part of the second cam surface 511 is completely inserted into the groove part of the first cam surface 513 means that rotation of the second cam surface 511 in any rotation direction relative to the first cam surface 513 causes the protrusion part of the second cam surface 511 to slide along the groove part of the first cam surface 513, so that the second cam surface 511 and the first cam surface 513 are relatively far away from each other. Therefore, in the second direction Y, when a size of the protrusion part of the second cam surface 511 is greater than a size of the groove part of the first cam surface 513, the protrusion part of the second cam surface 511 cannot be completely accommodated in the groove part of the first cam surface 513. However, that an end portion of the protrusion part of the second cam surface 511 is in contact with a bottom wall of the groove part of the first cam surface 513 may also be understood that the protrusion part of the second cam surface 511 is completely inserted into the groove part of the first cam surface 513.

Optionally, the end gear 231 is slidably connected to the first transmission shaft 220 in the second direction Y. The fastening support 100 is located at an end that is of the end gear 231 and that faces away from the first clamping member 310. Pressure that the first clamping member 310 presses the end gear 231 tightly is further transferred between the end gear 231 and the fastening support 100. When the rotation portion 077 connected to the first connecting member 230 moves, the end gear 231 rotates around the first transmission shaft 220 relative to the fastening support 100. The end gear 231 presses the fastening support 100 tightly in the second direction Y, so that the end gear 231 and the fastening support 100 rub against each other. When the end gear 231 has a trend of rotating around the first transmission shaft 220 relative to the fastening support 100, a static friction force is formed between the end gear 231 and the fastening support 100 to attenuate rotation of the end gear 231 relative to the fastening support 100. In this case, the rotation portion 077 connected to the first connecting member 230 may be in a stable position relationship relative to the base 050 connected to the fastening support 100. Corresponding to the foldable electronic device 001 shown in FIG. 2, in a process in which the foldable electronic device 001 moves from the unfolded state to the folded state, when the first housing 010 and the second housing 030 are in an intermediate state between the unfolded state and the folded state, the static friction force between the end gear 231 and the fastening support 100 may help the first housing 010 and the second housing 030 maintain the intermediate state, and assist in implementing hovering of the first housing 010 and the second housing 030.

Optionally, with reference to FIG. 5, FIG. 6, and FIG. 7, the hinge mechanism 070 further includes a second connecting member 610. A part of the second connecting member 610 is disposed between the second clamping member 330 and the fastening support 100. One second connecting member 610 is correspondingly disposed on each first transmission shaft 220. The second connecting member 610 is sleeved on the first transmission shaft 220, so that the second connecting member 610 can rotate around the axis center of the first transmission shaft 220 relative to the fastening support 100. The second connecting member 610 is configured to be connected to the rotation portion 077 on the side of the first housing 010 or on the side of the second housing 030. A first connecting member 230 and a second connecting member 610 that are located on a same first transmission shaft 220 are connected to a same rotation portion 077.

Optionally, the second connecting member 610 and the first connecting member 230 may be separated, so that the second connecting member 610 and the first connecting member 230 may be independently connected to the same rotation portion 077. In this way, the second connecting member 610 and the first connecting member 230 that are located on the same first transmission shaft 220 may further have relative displacement in the second direction Y. When the first elastic portion 400 acts on the second clamping member 330 by using the first transmission shaft 220, the second clamping member 330 may press the second connecting member 610, and the second connecting member 610 may press the first part 110 of the fastening support 100. In this way, a contact area is formed between the second clamping member 330 and the second connecting member 610, and a contact area is also formed between the second connecting member 610 and the fastening support 100. When the second connecting member 610 rotates around the first transmission shaft 220 relative to the fastening support 100, the two contact areas each may generate a friction force. When the rotation portion 077 connected to the second connecting member 610 moves, the second connecting member 610 is driven to rotate around the first transmission shaft 220 relative to the fastening support 100. The second connecting member 610 also rotates around the first transmission shaft 220 relative to the second clamping member 330. The second clamping member 330 presses the second connecting member 610 tightly in the second direction Y, so that the second clamping member 330 and the second connecting member 610 rub against each other. When the second connecting member 610 has a trend of rotating around the first transmission shaft 220 relative to the second clamping member 330, a static friction force is formed between the second clamping member 330 and the second connecting member 610 to attenuate the rotation trend of the second connecting member 610 relative to the second clamping member 330. In this case, the rotation portion 077 connected to the second connecting member 610 may be in a relatively stable position relationship relative to the base 050 connected to the fastening support 100. Corresponding to the foldable electronic device 001 shown in FIG. 2, in a process in which the foldable electronic device 001 moves from the unfolded state to the folded state, when the first housing 010 and the second housing 030 are in an intermediate state between the unfolded state and the folded state, the static friction force between the second clamping member 330 and the second connecting member 610 may help the first housing 010 and the second housing 030 maintain the intermediate state.

Optionally, an end that is of the second clamping member 330 and that faces the fastening support 100 has two third cam surfaces 533. An end that is of each second connecting member 610 and that faces the second clamping member 330 has a fourth cam surface 531. The third cam surface 533 rotates as the second connecting member 610 rotates. The fourth cam surface 531 rotates as the second connecting member 610 rotates. Because the second clamping member 330 cooperates around the circumference of the first transmission shaft 220 relative to the fastening support 100 in a limiting manner, the third cam surface 533 does not rotate as the end gear 231 rotates. The fourth cam surface 531 has a protrusion part and a groove part that are disposed around the circumference of the first transmission shaft 220, and the third cam surface 533 also has a protrusion part and a groove part that are disposed around the circumference of the first transmission shaft 220. When the protrusion part of the fourth cam surface 531 is inserted into the groove part of the third cam surface 533, the protrusion part of the third cam surface 533 is also inserted into the groove part of the fourth cam surface 531. The first elastic portion 400 acts on the second clamping member 330, so that the second clamping member 330 has a trend of moving toward the second connecting member 610, and the third cam surface 533 presses the fourth cam surface 531 tightly. When the protrusion part of the third cam surface 533 is not completely inserted into the groove part of the fourth cam surface 531, an elastic force provided by the first elastic portion 400 enables the protrusion part of the third cam surface 533 to have a trend of being further inserted into the groove part of the fourth cam surface 531. In addition, contact between the fourth cam surface 531 and the third cam surface 533 also generates a friction force, and the friction force may limit the protrusion part of the third cam surface 533 from being further inserted into the groove part of the fourth cam surface 531. Corresponding to the foldable electronic device 001 shown in FIG. 2, in a process in which the foldable electronic device 001 moves from the unfolded state to the folded state, when the first housing 010 and the second housing 030 are in an intermediate state between the unfolded state and the folded state, the friction force between the fourth cam surface 531 and the third cam surface 533 may help the first housing 010 and the second housing 030 maintain the intermediate state, and assist in implementing hovering of the first housing 010 and the second housing 030.

When the foldable electronic device 001 is in the unfolded state, the protrusion part of the fourth cam surface 531 is completely inserted into the groove part of the third cam surface 533. In this case, if the fourth cam surface 531 and the third cam surface 533 need to rotate relative to each other, a static friction force between the fourth cam surface 531 and the third cam surface 533 needs to be overcome, and an elastic force that the first elastic portion 400 prevents the fourth cam surface 531 and the third cam surface 533 from being relatively far away from each other in the second direction Y also needs to be overcome. Cooperation between the fourth cam surface 531 and the third cam surface 533 may limit the foldable electronic device 001 to be in the unfolded state more stably.

When the foldable electronic device 001 is in the folded state, the protrusion part of the fourth cam surface 531 is completely inserted into the groove part of the third cam surface 533. In this case, if the fourth cam surface 531 and the third cam surface 533 need to rotate relative to each other, a static friction force between the fourth cam surface 531 and the third cam surface 533 needs to be overcome, and an elastic force that the first elastic portion 400 prevents the fourth cam surface 531 and the third cam surface 533 from being relatively far away from each other in the second direction Y also needs to be overcome. Cooperation between the fourth cam surface 531 and the third cam surface 533 may limit the foldable electronic device 001 to be in the folded state more stably.

Optionally, the second connecting member 610 is slidably connected to the first transmission shaft 220 in the second direction Y. The fastening support 100 is located at an end that is of the second connecting member 610 and that faces away from the second clamping member 330. Pressure that the second clamping member 330 presses the second connecting member 610 tightly is further transferred between the second connecting member 610 and the fastening support 100. The second connecting member 610 presses the fastening support 100 tightly in the second direction Y, so that the second connecting member 610 and the fastening support 100 rub against each other. When the second connecting member 610 has a trend of rotating around the first transmission shaft 220 relative to the fastening support 100, a static friction force is formed between the second connecting member 610 and the fastening support 100 to attenuate rotation of the end gear 231 relative to the fastening support 100. In this case, the rotation portion 077 connected to the second connecting member 610 may be in a stable position relationship relative to the base 050 connected to the fastening support 100. Corresponding to the foldable electronic device 001 shown in FIG. 2, in a process in which the foldable electronic device 001 moves from the unfolded state to the folded state, when the first housing 010 and the second housing 030 are in an intermediate state between the unfolded state and the folded state, the static friction force between the second connecting member 610 and the fastening support 100 may help the first housing 010 and the second housing 030 maintain the intermediate state.

Steps of assembling the hinge mechanism 070 include: sequentially passing the first transmission shaft 220 through the second clamping member 330, the second connecting member 610, the fastening support 100, the end gear 231 of the first connecting member 230, the first clamping member 310, the first elastic member 410, and the first positioning member 430, and disposing the first stop member 221 on the rod body of the first transmission shaft 220.

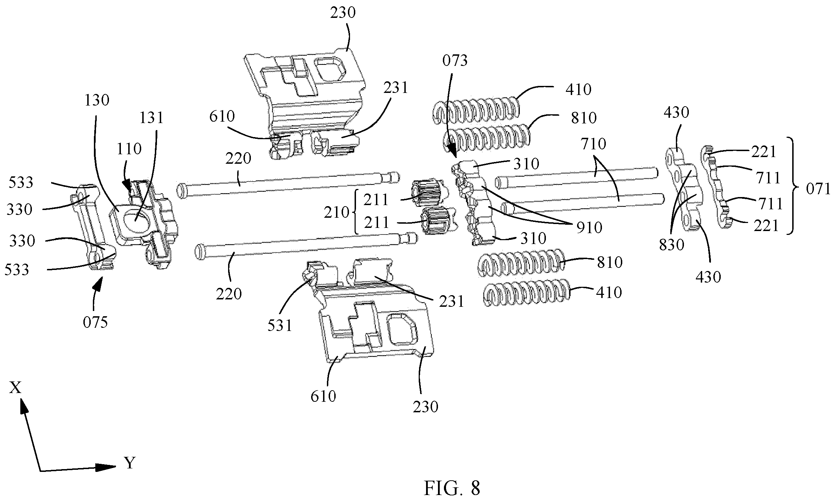

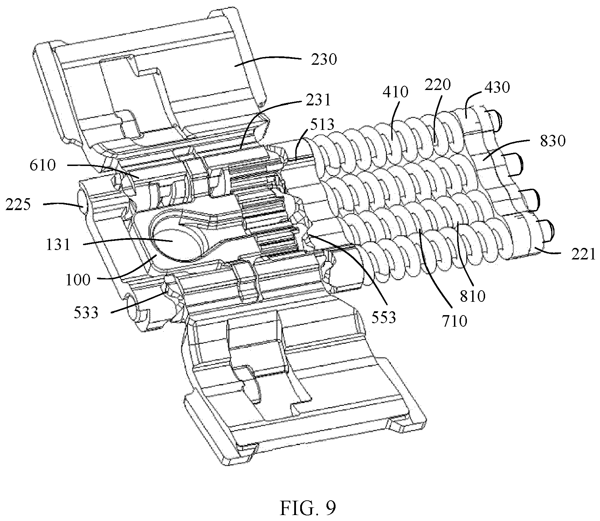

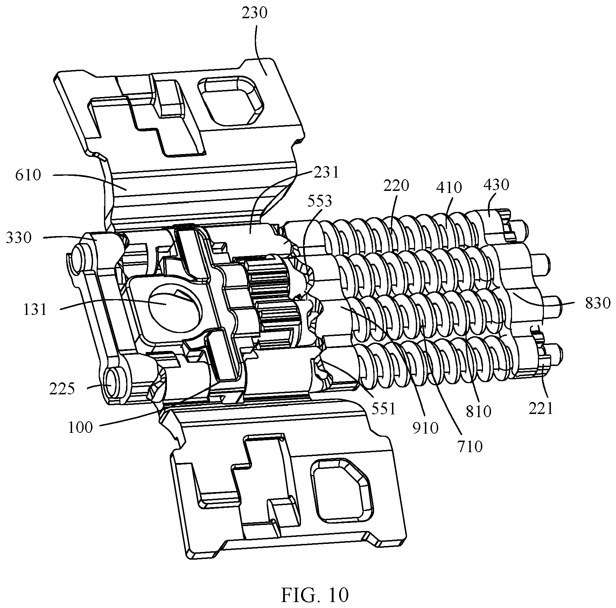

FIG. 8 is a diagram of assembling of the hinge mechanism 070 according to an implementation of this application. FIG. 9 is a diagram of a structure of the hinge mechanism 070 according to an implementation of this application. FIG. 10 is a diagram of a structure of the hinge mechanism 070 viewed from another angle according to an implementation of this application.

Refer to FIG. 8, FIG. 9, and FIG. 10. The first connecting member 230 and the second connecting member 610 in the hinge mechanism 070 may alternatively be fastened. When the first connecting member 230 and the second connecting member 610 are fastened, the first connecting member 230 and the second connecting member 610 move synchronously in the second direction Y. The first connecting member 230 and the second connecting member 610 rotate synchronously relative to the first transmission shaft 220, so that the first connecting member 230 and the second connecting member 610 are simultaneously connected to the rotation portion 077.

Optionally, the first connecting member 230 and the second connecting member 610 are integrated, to facilitate manufacturing of the first connecting member 230 and the second connecting member 610.

When the hinge mechanism 070 is assembled, the first part 110 of the fastening support 100 may be first extended between the second connecting member 610 and the end gear 231. Then, the first transmission shaft 220 sequentially passes through the second clamping member 330, the second connecting member 610, the fastening support 100, the end gear 231 of the first connecting member 230, the first clamping member 310, the first elastic member 410, and the first positioning member 430.

Refer to FIG. 5, FIG. 6, and FIG. 7. The hinge mechanism 070 further includes a second transmission shaft 710. The second transmission shaft 710 extends in the second direction Y. The second transmission shaft 710 is in one-to-one correspondence with the middle gear 211. The fastening support 100 has a limiting slot 103 that is in one-to-one correspondence with the middle gear 211. Optionally, there are two middle gears 211, two limiting slots 103, and two second transmission shafts 710. The second transmission shaft 710 is inserted into the limiting slot 103, and relative positions of the second transmission shaft 710 and the base 050 may be limited by using the limiting slot 103. The second transmission shaft 710 passes through a second mounting hole of the middle gear 211 and is inserted into the limiting slot 103 of the fastening support 100, to connect the second transmission shaft 710, the fastening support 100, and the middle gear 211. An end portion of the second transmission shaft 710 is accommodated in the limiting slot 103, to reduce space occupied by the second transmission shaft 710 in the hinge mechanism 070, and facilitate placement of the second part 130 of the fastening support 100. An accommodation space is formed between the second clamping member 330, the two second connecting members 610, and the first part 110 of the fastening support 100. The second part 130 of the fastening support 100 is accommodated in the accommodating space, so that the second part 130 of the fastening support 100 is disposed in close contact with the base 050, to facilitate a connection between the base 050 and the second part 130 of the fastening support 100.

The hinge mechanism 070 further includes a second elastic portion 800 and a third clamping member 910. The third clamping member 910 is sleeved on the two second transmission shafts 710, and is located at an end that is of the middle gear 211 and that faces away from the fastening support 100. The second elastic portion 800 is disposed on the second transmission shaft 710. The second elastic portion 800 is in a force storage state to provide an elastic force for the third clamping member 910, so that the third clamping member 910 presses the middle gear 211 toward the fastening support 100 in the second direction Y. Optionally, the second elastic portion 800 includes a second elastic member 810 and a second positioning member 830. One second elastic member 810 is sleeved on each second transmission shaft 710. The second positioning member 830 is located on a side that is of the third clamping member 910 and that faces away from the middle gear 211. The second positioning member 830 and the third clamping member 910 are disposed at intervals in the second direction Y, and the second elastic member 810 is clamped between the third clamping member 910 and the second positioning member 830. The second elastic member 810 generates an elastic force that makes the third clamping member 910 and the second positioning member 830 to be relatively far away from each other. When relative movement of the second positioning member 830 and the second transmission shaft 710 in the second direction Y is limited, an elastic force of the second elastic member 810 acts on the third clamping member 910 to press the third clamping member 910 toward the middle gear 211. Optionally, the second elastic member 810 is a compression spring, and when the compression spring is compressed, elastic potential energy can be stored, and an elastic force can be generated. As the compression spring is further compressed, the compression spring can generate a greater elastic force. When the compression spring is elongated, the elastic potential energy is released and a generated elastic force is reduced.

Optionally, a third stop member 711 is disposed on the second transmission shaft 710. The third stop member 711 is disposed at an end that is of the second positioning member 830 and that faces away from the third clamping member 910. A second guide hole is provided on the second positioning member 830. The second transmission shaft 710 passes through the second guide hole to limit relative movement of the second positioning member 830 and the second transmission shaft 710. Along a projection surface perpendicular to the second direction Y, a projection of the third stop member 711 is at least partially located outside the second guide hole. In this way, when the second positioning member 830 moves to be in contact with the third stop member 711, the third stop member 711 may limit the second positioning member 830 from passing through the third stop member 711 in the second direction Y, to limit the second positioning member 830 from being detached from the second transmission shaft 710 in the second direction Y

Optionally, the second positioning member 830 is fastened to the first positioning member 430. The first positioning member 430 and the second positioning member 830 may be integrated, so that the first positioning member 430 and the second positioning member 830 are integrally formed to keep the first positioning member 430 and the second positioning member 830 fastened in relative positions. The first positioning member 430 and the second positioning member 830 include a clamping plate. Four through holes are provided at intervals on the clamping plate in the first direction X. Among the four through holes, two through holes located at two ends in the first direction X are used for the first transmission shaft 220 to pass through, so that a part that is of the two ends of the clamping plate and that is in the first direction X forms the first positioning member 430. Among the four through holes, two through holes in a middle are used for the second transmission shaft 710 to pass through, so that a part in the middle of the clamping plate forms the second positioning member 830.

Optionally, the third stop member 711 is fastened to the first stop member 221. A relative position of the first stop member 221 relative to the first transmission shaft 220 in the second direction Y is limited, so that a relative position of the third stop member 711 relative to the first transmission shaft 220 in the second direction Y is limited. The first stop member 221 and the third stop member 711 may be integrated, and the first stop member 221 and the third stop member 711 include the snap ring 071. One first stop member 221 is formed at each of two ends of the snap ring 071 in the first direction X. Each first stop member 221 has one clamping groove. Each clamping groove correspondingly cooperates with one first transmission shaft 220, to limit relative movement of the snap ring 071 and the first transmission shaft 220 in the second direction Y. A part in the middle of the snap ring 071 forms two third stop members 711. When relative movement of the first stop member 221 and the first transmission shaft 220 is limited, relative movement of the third stop member 711 and the first transmission shaft 220 is also limited. Therefore, the third stop member 711 can apply pressure to the second elastic member 810.

It may be understood that, when the second transmission shaft 710 is fastened to the fastening support 100 in the second direction Y, the second positioning member 830 may also be fastened on the second transmission shaft 710. The third clamping member 910 slidably cooperates with the second transmission shaft 710 in the second direction Y, so that when the second elastic member 810 is squeezed by the third clamping member 910 and the second positioning member 830, the second elastic member 810 acts on the third clamping member 910, so that the third clamping member 910 presses the middle gear 211 tightly. If the hinge mechanism 070 is not provided with the second positioning member 830, an end that is of the second elastic member 810 and that faces away from the fastening support 100 may alternatively be fastened on the second transmission shaft 710. For example, the end that is of the second elastic member 810 and that faces away from the fastening support 100 is welded to the second transmission shaft 710.

The second elastic member 810 enables the third clamping member 910 to press the middle gear 211 tightly, and the middle gear 211 also presses the fastening support 100 tightly. When the end gear 231 drives the middle gear 211 to have a rotation trend, the middle gear 211 has a rotation trend relative to the third clamping member 910, and a friction force is generated between the third clamping member 910 and the middle gear 211 to attenuate the trend. When the end gear 231 drives the middle gear 211 to have a rotation trend, the middle gear 211 has a rotation trend relative to the fastening support 100, and a friction force is generated between the fastening support 100 and the middle gear 211 to attenuate the trend. Corresponding to the foldable electronic device 001 shown in FIG. 2, in a process in which the foldable electronic device 001 moves from the unfolded state to the folded state, the first housing 010 and the second housing 030 are in an intermediate state between the unfolded state and the folded state, both the friction force between the middle gear 211 and the fastening support 100 and the friction force between the middle gear 211 and the third clamping member 910 may help the first housing 010 and the second housing 030 maintain the intermediate state.

Optionally, an end that is of the third clamping member 910 and that faces the fastening support 100 has two fifth cam surfaces 553. An end that is of each middle gear 211 and that faces the third clamping member 910 has a sixth cam surface 551. The sixth cam surface 551 rotates as the middle gear 211 rotates. Because the third clamping member 910 cooperates around a circumference of the second transmission shaft 710 relative to the fastening support 100 in a limiting manner, the fifth cam surface 553 does not rotate as the middle gear 211 rotates. The sixth cam surface 551 has a protrusion part and a groove part that are disposed around the circumference of the second transmission shaft 710, and the fifth cam surface 553 also has a protrusion part and a groove part that are disposed around the circumference of the second transmission shaft 710. When the protrusion part of the sixth cam surface 551 is inserted into the groove part of the fifth cam surface 553, the protrusion part of the fifth cam surface 553 is also inserted into the groove part of the sixth cam surface 551. The second elastic portion 800 acts on the third clamping member 910, so that the third clamping member 910 has a trend of moving toward the middle gear 211, and the fifth cam surface 553 presses the sixth cam surface 551 tightly. When the protrusion part of the fifth cam surface 553 is not completely inserted into the groove part of the sixth cam surface 551, an elastic force provided by the second elastic portion 800 enables the protrusion part of the fifth cam surface 553 to be further inserted into the groove part of the sixth cam surface 551. In addition, contact between the sixth cam surface 551 and the fifth cam surface 553 also generates a friction force, and the friction force may limit the protrusion part of the fifth cam surface 553 from being further inserted into the groove part of the sixth cam surface 551. Corresponding to the foldable electronic device 001 shown in FIG. 2, in a process in which the foldable electronic device 001 moves from the unfolded state to the folded state, when the first housing 010 and the second housing 030 are in an intermediate state between the unfolded state and the folded state, the friction force between the sixth cam surface 551 and the fifth cam surface 553 may help the first housing 010 and the second housing 030 maintain the intermediate state.

When the foldable electronic device 001 is in the unfolded state, the protrusion part of the sixth cam surface 551 is completely inserted into the groove part of the fifth cam surface 553. In this case, if the sixth cam surface 551 and the fifth cam surface 553 need to rotate relative to each other, a static friction force between the sixth cam surface 551 and the fifth cam surface 553 needs to be overcome, and an elastic force that the second elastic portion 800 prevents the sixth cam surface 551 and the fifth cam surface 553 from being relatively far away from each other in the second direction Y also needs to be overcome. Cooperation between the sixth cam surface 551 and the fifth cam surface 553 may limit the foldable electronic device 001 to be in the unfolded state more stably.

When the foldable electronic device 001 is in the folded state, the protrusion part of the sixth cam surface 551 is completely inserted into the groove part of the fifth cam surface 553. In this case, if the sixth cam surface 551 and the fifth cam surface 553 need to rotate relative to each other, a static friction force between the sixth cam surface 551 and the fifth cam surface 553 needs to be overcome, and an elastic force that the second elastic portion 800 prevents the sixth cam surface 551 and the fifth cam surface 553 from being relatively far away from each other in the second direction Y also needs to be overcome. Cooperation between the sixth cam surface 551 and the fifth cam surface 553 may limit the foldable electronic device 001 to be in the folded state more stably.

Optionally, the third clamping member 910 is fastened to the first clamping member 310. The third clamping member 910 and the first clamping member 310 may be integrated, so that the third clamping member 910 and the first clamping member 310 can be integrated formed to keep the third clamping member 910 and the first clamping member 310 fastened in relative positions. For example, the first clamping member 310 is a part of two ends that are of one four-conjoined cam and that are in the first direction X. The third clamping member 910 is a part in a middle of the four-conjoined cam. The four-conjoined cam is simultaneously connected to the two first transmission shafts 220 and the two second transmission shafts 710, to limit the four-conjoined cam from rotating relative to the fastening support 100 around any one of the first transmission shafts 220 or any one of the second transmission shafts 710. When the end gear 231 and the middle gear 211 rotate, the end gear 231 may rotate relative to the first clamping member 310, and the middle gear 211 may rotate relative to the third clamping member 910. A first cam surface and a fifth cam surface are further formed on the four-conjoined cam.

When the foldable electronic device 001 is used, the first housing 010 and the second housing 030 rotate toward each other, so that the foldable electronic device 001 may enter the folded state; or the first housing 010 and the second housing 030 rotate away from each other, so that the foldable electronic device 001 may enter the unfolded state. When the first housing 010 rotates relative to the base 050, the first housing 010 moves relative to the base 050, to drive an end gear 231 corresponding to the first housing 010 to rotate. Through transmission of the transmission gear group 210, an end gear 231 corresponding to the second housing 030 rotates, to drive the second housing 030 to rotate relative to the base 050. The fastening support 100 is fastened to the base 050. The first transmission shaft 220 passes through the limiting hole 101 of the fastening support 100, and the second transmission shaft 710 extends into the limiting slot 103 of the fastening support 100. Relative positions of the first transmission shaft 220, the second transmission shaft 710, and the base 050 may be limited by using the fastening support 100. When the first housing 010 rotates relative to the base 050, offsets of the first transmission shaft 220 and the second transmission shaft 710 relative to the base 050 may be reduced, and stability of relative rotation of the first housing 010 and the second housing 030 is improved. The fastening support 100 is disposed at a position between the first clamping member 310 and the second clamping member 330, to fully utilize space in the foldable electronic device 001. Space occupied by the hinge mechanism 070 in the foldable electronic device 001 is reduced. The first clamping member 310 and the second clamping member 330 clamp the second connecting member 610, the fastening support 100, and the end gear 231, to form damping between the first clamping member 310 and the end gear 231, and form damping between the second clamping member 330 and the second connecting member 610. Therefore, when the foldable electronic device 001 is in the intermediate state between the unfolded state and the folded state, stability of the foldable electronic device 001 in the intermediate state is improved. The second transmission shaft 710 may guide the second elastic portion 800 to store a force. The second transmission shaft 710 is disposed, so that the second elastic portion 800 may be installed, to provide greater damping, improve the stability of the foldable electronic device 001 in the intermediate state, and assist in implementing hovering of the first housing 010 and the second housing 030. The second transmission shaft 710 is limited to the limiting slot 103 of the fastening support 100, so that the second transmission shaft 710 does not extend out from the first part 110 of the fastening support 100, and an accommodation space is formed between the second clamping member 330, the two second connecting members 610, and the first part 110 of the fastening support 100. The second part 130 of the fastening support 100 is accommodated in the accommodating space, so that the second part 130 of the fastening support 100 is disposed in close contact with the base 050, to facilitate a connection between the base 050 and the second part 130 of the fastening support 100.

The foregoing descriptions are merely specific implementations of this application, but are not intended to limit the protection scope of this application. Any variation or replacement within a technical scope disclosed in this application shall fall within the protection scope of this application.

## Claims

1. A hinge mechanism (070), comprising:
a fastening support (100), wherein the fastening support (100) has two limiting holes (101) provided at intervals in a first direction;
a transmission assembly (200), comprising two first connecting members (230) located on two sides of the fastening support (100) in the first direction and a transmission gear group (210), wherein each first connecting member (230) has one end gear (231), the transmission gear group (210) is located between two end gears (231) and engaged with the two end gears (231), each end gear (231) is fixed relative to one first connecting member (230) located on a same side, and each first connecting member (230) is configured to be connected to one rotation portion (077) located on a same side;
two first transmission shafts (220), wherein the first transmission shafts (220) extend in a second direction, the second direction is perpendicular to the first direction, the two first connecting members (230) each rotate relative to the fastening support (100) by using one first transmission shaft (220), and each first transmission shaft (220) passes through a corresponding end gear (231) and a corresponding limiting hole (101);
a clamping assembly (300), wherein the clamping assembly (300) cooperates around a circumference of the first transmission shafts (220) relative to the fastening support (100) in a limiting manner, the clamping assembly (300) comprises a first clamping member (310) and a second clamping member (330), both the first clamping member (310) and the second clamping member (330) are sleeved on the two first transmission shafts (220), and clamp the fastening support (100) and the transmission assembly (200) in the second direction, and the first transmission shafts (220) are connected to the second clamping member (330) in a limiting manner in the second direction, so that the first transmission shafts (220) can drive the second clamping member (330) to be relatively close to the fastening support (100) in the second direction; and
a first elastic portion (400), wherein one end of the first elastic portion (400) acts on the first clamping member (310), and the other end acts on the first transmission shafts (220), so that the first clamping member (310) and the second clamping member (330) clamp the fastening support (100) and the transmission assembly (200) in the second direction,
wherein the fastening support (100) is located at an end of the end gears (231) that faces away from the first clamping member (310), the first clamping member (310) is located at an end of the transmission assembly (200) that faces away from the fastening support (100), and the second clamping member (330) is located at an end of the fastening support (100) that faces away from the transmission assembly (200).

2. The hinge mechanism (070) according to claim 1, wherein
the first clamping member (310) is located at an end that is of the transmission assembly (200) and that faces away from the fastening support (100), and an end that is of the first clamping member (310) and that faces the fastening support (100) has two first cam surfaces (513);
an end that is of each first connecting member (230) and that faces the first clamping member (310) has a second cam surface (511); and
the first elastic portion (400) enables the first clamping member (310) and the second clamping member (330) to clamp the fastening support (100) and the transmission assembly (200) in the second direction, and the second cam surface (511) abuts against the first cam surface (513).

3. The hinge mechanism (070) according to claim 1, wherein the hinge mechanism (070) further comprises two second connecting members (610) located on the two sides of the fastening support (100) in the first direction, and each second connecting member (610) is configured to be connected to one rotation portion (077) located on a same side;
the second clamping member (330) is located at an end that is of the fastening support (100) and that faces away from the transmission assembly (200), and an end that is of the second clamping member (610) and that faces the fastening support (100) has a third cam surface (533);
each second connecting member (610) is disposed between the second clamping member (330) and the fastening support (100);
an end that is of each second connecting member (610) and that faces the second clamping member (330) has a fourth cam surface (531); and
the first clamping member (310) and the second clamping member (530) clamp the second connecting member (610), the fastening support (100), and the transmission assembly (200) in the second direction, and the third cam surface (533) abuts against the fourth cam surface (531).

4. The hinge mechanism (070) according to claim 3, wherein the first connecting member (230) and the second connecting member (610) are fastened to or integrated with each other.

5. The hinge mechanism (070) according to claim 1, wherein the fastening support (100) comprises a first part (110) and a second part (130) in the second direction, and the two limiting holes (101) are provided on the first part (110); and
the second part (130) is disposed between the two first transmission shafts (220), and is configured to be fastened to a fastening portion (051).

6. The hinge mechanism (070) according to any one of claims 1 to 5, wherein the transmission gear group (200) comprises a middle gear (211);
the hinge mechanism (070) further comprises a second transmission shaft (710), and the second transmission (710) shaft extends in the second direction; and
the fastening support (100) further has a limiting slot (103), and the second transmission shaft (710) passes through the middle gear (211) and is inserted into the limiting slot (103), to limit movement of the middle gear (211) relative to the fastening support (100).

7. The hinge mechanism (070) according to claim 6, wherein the first elastic portion (400) comprises a first elastic member (410) and a first positioning member (430);
the first positioning member (430) is disposed on the first transmission shaft (220), and is located on a side that is of the first clamping member (310) and that faces away from the second clamping member (330); and
the first elastic member (410) is clamped between the first clamping member (310) and the first positioning member (430).

8. The hinge mechanism (070) according to claim 7, wherein a first stop member (221) and a second stop member (225) are disposed on the first transmission shaft (220);
the first stop member (221) acts on the first positioning member (430), to limit the first positioning member (430) from being detached from the first transmission shaft (220) in the second direction; and
the second stop member (225) acts on the second clamping member (610), to limit the second clamping member (610) from being detached from the first transmission shaft (220) in the second direction.

9. The hinge mechanism (070) according to claim 7, wherein the hinge mechanism (200) further comprises a second elastic portion (800) and a third clamping member (910);
both the second elastic portion (800) and the third clamping member (910) are disposed on the second transmission shaft (710);
the middle gear (210) is clamped between the fastening support (100) and the third clamping member (910); and
the second elastic portion (800) acts on the third clamping member (910) to press the third clamping member (910) toward the middle gear (210) in the second direction.

10. The hinge mechanism (070) according to claim 9, wherein the third clamping member (910) is located at the end that is of the transmission assembly (200) and that faces away from the fastening support (100), and an end that is of the third clamping member (910) and that faces the fastening support (100) has two fifth cam surfaces (553);
an end that is of each middle gear (221) and that faces the third clamping member (910) has a sixth cam surface (551); and
the second elastic portion (800) enables the third clamping member (90) to press the middle gear (211) in the second direction, and the fifth cam surface (553) abuts against the sixth cam surface (551).

11. The hinge mechanism (070) according to claim 9, wherein the third clamping member (910) and the first clamping member (310) are fastened or integrated.

12. The hinge mechanism (070) according to claim 9, wherein the second elastic portion (800) comprises a second elastic member (810) and a second positioning member (830);
the second positioning member (830) is disposed on the second transmission shaft (710), and is located on a side that is of the third clamping member (910) and that faces away from the middle gear (211);
the second positioning member (830) is fastened to the first positioning member (430); and
the second elastic member (810) is clamped between the third clamping member (910) and the second positioning member (830), and the second elastic member (810) acts on the third clamping member (910) and the second positioning member (830), so that the third clamping member (910) presses the middle gear (211) toward the fastening support (100) in the second direction.

13. The hinge mechanism (070) according to claim 12, wherein the first positioning member (430) and the second positioning member (830) are fastened or integrated.

14. A foldable electronic device (001), comprising a first housing (010) and a second housing (030), wherein the foldable electronic device (001) further comprises the hinge mechanism (070) according to any one of claims 1 to 13;
the first housing (010) is connected to one first connecting member (230), and the second housing (030) is connected to the other first connecting member (230); and
the first housing (010) and the second housing (030) rotate toward each other or away from each other by using the hinge mechanism (070) to implement relative folding or unfolding.

## Patentansprüche

1. Scharniermechanismus (070), der umfasst:
einen Befestigungsträger (100), wobei der Befestigungsträger (100) zwei Begrenzungslöcher (101) aufweist, die in Abständen in einer ersten Richtung bereitgestellt sind;
eine Getriebeanordnung (200), die zwei erste Verbindungselemente (230), die auf zwei Seiten des Befestigungsträgers (100) in der ersten Richtung angeordnet sind, und eine Getriebezahnradgruppe (210) umfasst, wobei jedes erste Verbindungselement (230) ein Endzahnrad (231) aufweist, die
Getriebezahnradgruppe (210) zwischen zwei Endzahnrädern (231) angeordnet ist und mit den zwei Endzahnrädern (231) in Eingriff steht, jedes Endzahnrad (231) relativ zu einem auf einer gleichen Seite angeordneten ersten Verbindungselement (230) fixiert ist und jedes erste Verbindungselement (230) konfiguriert ist, um mit einem auf einer gleichen Seite angeordneten Drehabschnitt (077) verbunden zu werden;
zwei erste Getriebewellen (220), wobei sich die ersten Getriebewellen (220) in einer zweiten Richtung erstrecken, die zweite Richtung senkrecht zu der ersten Richtung verläuft, sich die zwei ersten Verbindungselemente (230) jeweils unter Verwendung einer ersten Getriebewelle (220) relativ zu dem Befestigungsträger (100) drehen und jede erste Getriebewelle (220) durch ein entsprechendes Endzahnrad (231) und ein entsprechendes Begrenzungsloch (101) verläuft;
eine Klemmanordnung (300), wobei die Klemmanordnung (300) um einen Umfang der ersten Getriebewellen (220) relativ zu dem Befestigungsträger (100) auf begrenzende Weise zusammenwirkt, die Klemmanordnung (300) ein erstes Klemmelement (310) und ein zweites Klemmelement (330) umfasst, sowohl das erste Klemmelement (310) als auch das zweite Klemmelement (330) auf die zwei ersten Getriebewellen (220) aufgeschoben sind und den Befestigungsträger (100) und die Getriebeanordnung (200) in der zweiten Richtung einklemmen, und die ersten Getriebewellen (220) mit dem zweiten Klemmelement (330) in der zweiten Richtung auf begrenzende Weise verbunden sind, sodass die ersten Getriebewellen (220) das zweite Klemmelement (330) antreiben können, um in der zweiten Richtung relativ nah an dem Befestigungsträger (100) zu sein; und
einen ersten elastischen Abschnitt (400), wobei ein Ende des ersten elastischen Abschnitts (400) auf das erste Klemmelement (310) wirkt und das andere Ende auf die ersten Getriebewellen (220) wirkt, sodass das erste Klemmelement (310) und das zweite Klemmelement (330) den Befestigungsträger (100) und die Getriebeanordnung (200) in der zweiten Richtung einklemmen,
wobei der Befestigungsträger (100) an einem Ende der Endzahnräder (231) angeordnet ist, das von dem ersten Klemmelement (310) abgewandt ist, das erste Klemmelement (310) an einem Ende der Getriebeanordnung (200) angeordnet ist, das von dem Befestigungsträger (100) abgewandt ist, und das zweite Klemmelement (330) an einem Ende des Befestigungsträgers (100) angeordnet ist, das von der Getriebeanordnung (200) abgewandt ist.

2. Scharniermechanismus (070) nach Anspruch 1, wobei
das erste Klemmelement (310) an einem Ende der Getriebeanordnung (200) angeordnet ist, das von dem Befestigungsträger (100) abgewandt ist, und ein Ende des ersten Klemmelements (310), das dem Befestigungsträger (100) zugewandt ist, zwei erste Nockenoberflächen (513) aufweist;
ein Ende jedes ersten Verbindungselements (230), das dem ersten Klemmelement (310) zugewandt ist, eine zweite Nockenoberfläche (511) aufweist; und der erste elastische Abschnitt (400) es dem ersten Klemmelement (310) und dem zweiten Klemmelement (330) ermöglicht, den Befestigungsträger (100) und die Getriebeanordnung (200) in der zweiten Richtung einzuklemmen, und die zweite Nockenoberfläche (511) an der ersten Nockenoberfläche (513) anliegt.

3. Scharniermechanismus (070) nach Anspruch 1, wobei der Scharniermechanismus (070) ferner zwei zweite Verbindungselemente (610) umfasst, die auf den beiden Seiten des Befestigungsträgers (100) in der ersten Richtung angeordnet sind, und jedes zweite Verbindungselement (610) konfiguriert ist, um mit einem Drehabschnitt (077) verbunden zu werden, der auf einer gleichen Seite angeordnet ist;
das zweite Klemmelement (330) an einem Ende des Befestigungsträgers (100) angeordnet ist, das von der Getriebeanordnung (200) abgewandt ist, und ein Ende des zweiten Klemmelements (610), das dem Befestigungsträger (100) zugewandt ist, eine dritte Nockenoberfläche (533) aufweist;
jedes zweite Verbindungselement (610) zwischen dem zweiten Klemmelement (330) und dem Befestigungsträger (100) angeordnet ist;
ein Ende jedes zweiten Verbindungselements (610), das dem zweiten Klemmelement (330) zugewandt ist, eine vierte Nockenoberfläche (531) aufweist; und das erste Klemmelement (310) und das zweite Klemmelement (530) das zweite Verbindungselement (610), den Befestigungsträger (100) und die Getriebeanordnung (200) in der zweiten Richtung einklemmen, und die dritte Nockenoberfläche (533) an der vierten Nockenoberfläche (531) anliegt.

4. Scharniermechanismus (070) nach Anspruch 3, wobei das erste Verbindungselement (230) und das zweite Verbindungselement (610) aneinander befestigt oder miteinander integriert sind.

5. Scharniermechanismus (070) nach Anspruch 1, wobei der Befestigungsträger (100) einen ersten Teil (110) und einen zweiten Teil (130) in der zweiten Richtung umfasst, und die zwei Begrenzungslöcher (101) an dem ersten Teil (110) bereitgestellt sind; und der zweite Teil (130) zwischen den zwei ersten Getriebewellen (220) angeordnet und konfiguriert ist, um an einem Befestigungsabschnitt (051) befestigt zu werden.

6. Scharniermechanismus (070) nach einem der Ansprüche 1 bis 5, wobei die Getriebezahnradgruppe (200) ein mittleres Zahnrad (211) umfasst;
der Scharniermechanismus (070) ferner eine zweite Getriebewelle (710) umfasst, und die zweite Getriebewelle (710) sich in die zweite Richtung erstreckt; und
der Befestigungsträger (100) ferner einen Begrenzungsschlitz (103) aufweist, und die zweite Getriebewelle (710) durch das mittlere Zahnrad (211) verläuft und in den Begrenzungsschlitz (103) eingesetzt ist, um die Bewegung des mittleren Zahnrads (211) relativ zu dem Befestigungsträger (100) zu begrenzen.

7. Scharniermechanismus (070) nach Anspruch 6, wobei der erste elastische Abschnitt (400) ein erstes elastisches Element (410) und ein erstes Positionierungselement (430) umfasst; das erste Positionierungselement (430) an der ersten Getriebewelle (220) angeordnet ist und sich auf einer Seite des ersten Klemmelements (310) befindet, die dem zweiten Klemmelement (330) abgewandt ist; und
das erste elastische Element (410) zwischen das erste Klemmelement (310) und das erste Positionierungselement (430) geklemmt ist.

8. Scharniermechanismus (070) nach Anspruch 7, wobei ein erstes Anschlagelement (221) und ein zweites Anschlagelement (225) an der ersten Getriebewelle (220) angeordnet sind;
das erste Anschlagelement (221) auf das erste Positionierungselement (430) wirkt,
um zu verhindern, dass das erste Positionierungselement (430) in der zweiten Richtung von der ersten Getriebewelle (220) gelöst wird; und
das zweite Anschlagelement (225) auf das zweite Klemmelement (610) wirkt, um zu verhindern, dass das zweite Klemmelement (610) in der zweiten Richtung von der ersten Getriebewelle (220) gelöst wird.

9. Scharniermechanismus (070) nach Anspruch 7, wobei der
Scharniermechanismus (200) ferner einen zweiten elastischen Abschnitt (800) und ein drittes Klemmelement (910) umfasst;
sowohl der zweite elastische Abschnitt (800) als auch das dritte Klemmelement (910) an der zweiten Getriebewelle (710) angeordnet sind;
das mittlere Zahnrad (210) zwischen den Befestigungsträger (100) und das dritte Klemmelement (910) geklemmt ist; und
der zweite elastische Abschnitt (800) auf das dritte Klemmelement (910) wirkt, um das dritte Klemmelement (910) in der zweiten Richtung in Richtung des mittleren Zahnrads (210) zu drücken.

10. Scharniermechanismus (070) nach Anspruch 9, wobei sich das dritte Klemmelement (910) an dem Ende der Getriebeanordnung (200) befindet, das von dem Befestigungsträger (100) abgewandt ist, und ein Ende des dritten Klemmelements (910), das dem Befestigungsträger (100) zugewandt ist, zwei fünfte Nockenoberflächen (553) aufweist;
ein Ende jedes mittleren Zahnrads (221), das dem dritten Klemmelement (910) zugewandt ist, eine sechste Nockenoberfläche (551) aufweist; und
der zweite elastische Abschnitt (800) es dem dritten Klemmelement (90) ermöglicht, das mittlere Zahnrad (211) in die zweite Richtung zu drücken, und die fünfte Nockenoberfläche (553) an der sechsten Nockenoberfläche (551) anliegt.

11. Scharniermechanismus (070) nach Anspruch 9, wobei das dritte Klemmelement (910) und das erste Klemmelement (310) befestigt oder integriert sind.

12. Scharniermechanismus (070) nach Anspruch 9, wobei der zweite elastische Abschnitt (800) ein zweites elastisches Element (810) und ein zweites Positionierungselement (830) umfasst;
das zweite Positionierungselement (830) an der zweiten Getriebewelle (710) angeordnet ist und sich auf einer Seite des dritten Klemmelements (910) befindet, die dem mittleren Zahnrad (211) abgewandt ist;
das zweite Positionierungselement (830) an dem ersten Positionierungselement (430) befestigt ist; und
das zweite elastische Element (810) zwischen das dritte Klemmelement (910) und das zweite Positionierungselement (830) geklemmt ist, und das zweite elastische Element (810) auf das dritte Klemmelement (910) und das zweite Positionierungselement (830) wirkt, sodass das dritte Klemmelement (910) das mittlere Zahnrad (211) in der zweiten Richtung in Richtung des Befestigungsträgers (100) drückt.

13. Scharniermechanismus (070) nach Anspruch 12, wobei das erste Positionierungselement (430) und das zweite Positionierungselement (830) befestigt oder integriert sind.

14. Klappbare elektronische Vorrichtung (001), die ein erstes Gehäuse (010) und ein zweites Gehäuse (030) umfasst, wobei die klappbare elektronische Vorrichtung (001) ferner den Scharniermechanismus (070) nach einem der Ansprüche 1 bis 13 umfasst; das erste Gehäuse (010) mit einem ersten Verbindungselement (230) verbunden ist und das zweite Gehäuse (030) mit dem anderen ersten Verbindungselement (230) verbunden ist; und
das erste Gehäuse (010) und das zweite Gehäuse (030) sich unter Verwendung des Scharniermechanismus (070) aufeinander zu oder voneinander weg drehen, um ein relatives Zusammenklappen oder Aufklappen zu bewirken.

## Revendications

1. Mécanisme de charnière (070), comprenant :
un support de fixation (100), dans lequel le support de fixation (100) présente deux trous de limitation (101) prévus à intervalles dans une première direction ;
un ensemble de transmission (200), comprenant deux premiers éléments de liaison (230) situés sur deux côtés du support de fixation (100) dans la première direction et un groupe d'engrenages de transmission (210), dans lequel chaque premier élément de liaison (230) présente un engrenage d'extrémité (231), le groupe d'engrenages de transmission (210) est situé entre deux engrenages d'extrémité (231) et mis en prise avec les deux engrenages d'extrémité (231), chaque engrenage d'extrémité (231) est fixe par rapport à un premier élément de liaison (230) situé sur un même côté, et chaque premier élément de liaison (230) est conçu pour être relié à une partie de rotation (077) située sur un même côté ;
deux premiers arbres de transmission (220), dans lequel les premiers arbres de transmission (220) s'étendent dans une seconde direction, la seconde direction est perpendiculaire à la première direction, les deux premiers éléments de liaison (230) tournent chacun par rapport au support de fixation (100) en utilisant un premier arbre de transmission (220), et chaque premier arbre de transmission (220) passe à travers un engrenage d'extrémité (231) correspondant et un trou de limitation (101) correspondant ;
un ensemble de serrage (300), dans lequel l'ensemble de serrage (300) coopère autour d'une circonférence des premiers arbres de transmission (220) par rapport au support de fixation (100) de manière limitative, l'ensemble de serrage (300) comprend un premier élément de serrage (310) et un deuxième élément de serrage (330), le premier élément de serrage (310) et le deuxième élément de serrage (330) sont tous deux emmanchés sur les deux premiers arbres de transmission (220), et serrent le support de fixation (100) et l'ensemble de transmission (200) dans la seconde direction, et les premiers arbres de transmission (220) sont reliés au deuxième élément de serrage (330) de manière limitative dans la seconde direction, de sorte que les premiers arbres de transmission (220) peuvent entraîner le deuxième élément de serrage (330) pour qu'il soit relativement proche du support de fixation (100) dans la seconde direction ; et
une première partie élastique (400), dans lequel une extrémité de la première partie élastique (400) agit sur le premier élément de serrage (310), et l'autre extrémité agit sur les premiers arbres de transmission (220), de sorte que le premier élément de serrage (310) et le deuxième élément de serrage (330) serrent le support de fixation (100) et l'ensemble de transmission (200) dans la seconde direction,
dans lequel le support de fixation (100) est situé au niveau d'une extrémité des engrenages d'extrémité (231) qui est orientée à l'opposé du premier élément de serrage (310), le premier élément de serrage (310) est situé au niveau d'une extrémité de l'ensemble de transmission (200) qui est orientée à l'opposé du support de fixation (100), et le deuxième élément de serrage (330) est situé au niveau d'une extrémité du support de fixation (100) qui est orientée à l'opposé de l'ensemble de transmission (200).

2. Mécanisme de charnière (070) selon la revendication 1, dans lequel
le premier élément de serrage (310) est situé au niveau d'une extrémité de l'ensemble de transmission (200) qui est orientée à l'opposé du support de fixation (100), et une extrémité du premier élément de serrage (310) et qui est orientée vers le support de fixation (100) présente deux premières surfaces de came (513) ;
une extrémité de chaque premier élément de liaison (230) et qui est orientée vers le premier élément de serrage (310) présente une deuxième surface de came (511) ; et la première partie élastique (400) permet au premier élément de serrage (310) et au deuxième élément de serrage (330) de serrer le support de fixation (100) et l'ensemble de transmission (200) dans la seconde direction, et la deuxième surface de came (511) vient en butée contre la première surface de came (513).

3. Mécanisme de charnière (070) selon la revendication 1, dans lequel le mécanisme de charnière (070) comprend en outre deux seconds éléments de liaison (610) situés sur les deux côtés du support de fixation (100) dans la première direction, et chaque second élément de liaison (610) est conçu pour être relié à une partie de rotation (077) située sur un même côté ;
le deuxième élément de serrage (330) est situé au niveau d'une extrémité du support de fixation (100) qui est orientée à l'opposé de l'ensemble de transmission (200), et une extrémité du deuxième élément de serrage (610) qui est orientée vers le support de fixation (100) présente une troisième surface de came (533) ;
chaque second élément de liaison (610) est disposé entre le deuxième élément de serrage (330) et le support de fixation (100) ;
une extrémité de chaque second élément de liaison (610) qui est orientée vers le deuxième élément de serrage (330) présente une quatrième surface de came (531) ; et
le premier élément de serrage (310) et le deuxième élément de serrage (530) serrent le second élément de liaison (610), le support de fixation (100) et l'ensemble de transmission (200) dans la seconde direction, et la troisième surface de came (533) vient en butée contre la quatrième surface de came (531).

4. Mécanisme de charnière (070) selon la revendication 3, dans lequel le premier élément de liaison (230) et le second élément de liaison (610) sont fixés l'un à l'autre ou intégrés l'un à l'autre.

5. Mécanisme de charnière (070) selon la revendication 1, dans lequel le support de fixation (100) comprend une première partie (110) et une seconde partie (130) dans la seconde direction, et les deux trous de limitation (101) sont prévus sur la première partie (110) ; et
la seconde partie (130) est disposée entre les deux premiers arbres de transmission (220), et est conçue pour être fixée à une partie de fixation (051).

6. Mécanisme de charnière (070) selon l'une quelconque des revendications 1 à 5, dans lequel le groupe d'engrenages de transmission (200) comprend un engrenage intermédiaire (211) ;
le mécanisme de charnière (070) comprend en outre un second arbre de transmission (710), et le second arbre de transmission (710) s'étend dans la seconde direction ; et
le support de fixation (100) présente en outre une fente de limitation (103), et le second arbre de transmission (710) passe à travers l'engrenage intermédiaire (211) et est inséré dans la fente de limitation (103), pour limiter le mouvement de l'engrenage intermédiaire (211) par rapport au support de fixation (100).

7. Mécanisme de charnière (070) selon la revendication 6, dans lequel la première partie élastique (400) comprend un premier élément élastique (410) et un premier élément de positionnement (430) ;
le premier élément de positionnement (430) est disposé sur le premier arbre de transmission (220) et est situé sur un côté du premier élément de serrage (310) qui est orienté à l'opposé du deuxième élément de serrage (330) ; et
le premier élément élastique (410) est serré entre le premier élément de serrage (310) et le premier élément de positionnement (430).

8. Mécanisme de charnière (070) selon la revendication 7, dans lequel un premier élément de butée (221) et un second élément de butée (225) sont disposés sur le premier arbre de transmission (220) ;
le premier élément de butée (221) agit sur le premier élément de positionnement (430), pour empêcher le premier élément de positionnement (430) de se détacher du premier arbre de transmission (220) dans la seconde direction ; et
le second élément de butée (225) agit sur le deuxième élément de serrage (610), pour empêcher le deuxième élément de serrage (610) de se détacher du premier arbre de transmission (220) dans la seconde direction.

9. Mécanisme de charnière (070) selon la revendication 7, dans lequel le mécanisme de charnière (200) comprend en outre une seconde partie élastique (800) et un troisième élément de serrage (910) ;
la seconde partie élastique (800) et le troisième élément de serrage (910) sont disposés sur le second arbre de transmission (710) ;
l'engrenage intermédiaire (210) est serré entre le support de fixation (100) et le troisième élément de serrage (910) ; et
la seconde partie élastique (800) agit sur le troisième élément de serrage (910) pour presser le troisième élément de serrage (910) vers l'engrenage intermédiaire (210) dans la seconde direction.

10. Mécanisme de charnière (070) selon la revendication 9, dans lequel le troisième élément de serrage (910) est situé au niveau de l'extrémité de l'ensemble de transmission (200) orientée à l'opposé du support de fixation (100), et une extrémité du troisième élément de serrage (910) orientée vers le support de fixation (100) présente deux cinquièmes surfaces de came (553) ;
une extrémité de chaque engrenage intermédiaire (221) orientée vers le troisième élément de serrage (910) présente une sixième surface de came (551) ; et
la seconde partie élastique (800) permet au troisième élément de serrage (90) de presser l'engrenage intermédiaire (211) dans la seconde direction, et la cinquième surface de came (553) vient en butée contre la sixième surface de came (551).

11. Mécanisme de charnière (070) selon la revendication 9, dans lequel le troisième élément de serrage (910) et le premier élément de serrage (310) sont fixés ou intégrés.

12. Mécanisme de charnière (070) selon la revendication 9, dans lequel la seconde partie élastique (800) comprend un second élément élastique (810) et un second élément de positionnement (830) ;
le second élément de positionnement (830) est disposé sur le second arbre de transmission (710) et est situé sur un côté du troisième élément de serrage (910) orienté à l'opposé de l'engrenage intermédiaire (211) ;
le second élément de positionnement (830) est fixé au premier élément de positionnement (430) ; et
le second élément élastique (810) est serré entre le troisième élément de serrage (910) et le second élément de positionnement (830), et le second élément élastique (810) agit sur le troisième élément de serrage (910) et le second élément de positionnement (830), de sorte que le troisième élément de serrage (910) presse l'engrenage intermédiaire (211) vers le support de fixation (100) dans la seconde direction.

13. Mécanisme de charnière (070) selon la revendication 12, dans lequel le premier élément de positionnement (430) et le second élément de positionnement (830) sont fixés ou intégrés.

14. Dispositif électronique pliable (001) comprenant un premier boîtier (010) et un second boîtier (030), dans lequel le dispositif électronique pliable (001) comprend en outre le mécanisme de charnière (070) selon l'une quelconque des revendications 1 à 13 ;
le premier boîtier (010) est relié à un premier élément de liaison (230), et le second boîtier (030) est relié à l'autre premier élément de liaison (230) ; et
le premier boîtier (010) et le second boîtier (030) tournent l'un vers l'autre ou s'éloignent l'un de l'autre en utilisant le mécanisme de charnière (070) pour mettre en œuvre un pliage ou un dépliage relatif.
